# EUROPEAN PATENT SPECIFICATION

(11) **EP 0 226 210 B1**
(45) Date of publication and mention of the grant of the patent: **07.01.1993**
(21) Application number: 86117527.1
(22) Date of filing: 17.12.1986
(51) Int. Cl.: G01R 31/08, G01R 31/11

(54) **Method for locating a fault on a power line and equipment for carrying out the method**
Methode zur Ortung eines Fehlers bei einer Energieleitung und Vorrichtung zur Durchführung der Methode
Méthode pour localiser un défaut dans une ligne de courant et dispositif pour procéder à cette méthode

(30) Priority: 20.12.1985 SE 8506061
(43) Date of publication of application: 24.06.1987
(73) Proprietor: ASEA AB, S-721 83 Västeras (SE)
(72) Inventor: Nimmersjö, Gunnar, S-722 42 Västeras (SE)
(74) Representative: Boecker, Joachim, Dr.-Ing.

(56) References cited:
- EP-A- 0 045 113
- EP-A- 0 106 790
- EP-A- 0 164 711
- GB-A- 2 036 478
- IEEE TRANSACTIONS ON POWER DELIVERY PWRD-1, no. 1, January 1986, pages 272-279, New York, US; M.M. MANSOUR et al.: "A Multi-microprocessor based travelling ware relay - Theory and Realisation"

## Description

The invention relates to a method for locating a fault on a power line according to the precharacterising part of claims 1 and 2. The invention also refers to equipment for carrying out the method.

The invention is designed for networks for the distribution or transmission of electric power, in which supply of power to the transmission line to he protected takes place at least substantially from one of the end points of the transmission line, and in which that part of the network which is to be protected is provided with measuring devices in a station or the like at either end of the object to be protected.

Distribution and transmission networks have to be protected against ground faults and faults occurring between the phases in such a way that a faulty component or transmission line is automatically disconnected with the aid of an associated circuit-breaker. This is necessary to minimize the risk of personal injury and fire.

After a fault has occurred and been detected, it is also very important to be able to eliminate the fault. This presupposes fast methods for locating the point on the transmission line where the fault has occurred.

The invention aims at developing a method and equipment for solving the afore-mentioned problem.

To achieve this aim the invention suggests two methods for locating a fault on a power line according to the claims 1 and 2, respectively.

Further developments of the invention are characterized by the features of the additional claims 3 to 8.

Equipment to carry out the method according to the invention is characterized by the features of the claims 9 and 10.

A method for fault location must necessarily be preceded by some form of fault detection. Fault detection can take place in many different ways which will not be described here, with the exception of the special method of detection which is a condition for the method and the equipment for fault location according to this invention. This detection will be described in connection with the disclosure of the present invention.

Concerning fault location on a transmission line, a plurality of different methods are known.

One such method is known from GB-A-2,036,478, in which a method is described by which a fault point is assumed and, under simplified assumptions of the parameters of the network, the current and the voltage at the fault point are determined. The determinations are repeated until the current and the voltage have the same phase, which means that the fault point has been located.

Another method is described in EP-A-0 106 790. This publication relates to a method for fault location on a section of a three-phase power line. After measurement of currents and voltages at one end of the section, the type of the fault is first determined and thereafter certain parameters in an equation system are determined. This system describes the relationships between the complex values of the impedance of the section, the impedances of the networks of the near end and of the remote end of the section, and measured currents and voltages while eliminating fault resistance, zero sequence components, etc. The solution of the equation system gives the distance from the end point of the section to the fault point in question.

EP-A-0 164 711 describes a method and a device for fault location of a fault point, which is based on using voltage waves emanating from a measuring point towards a fault point and corresponding waves reflected from a fault point, the waves being included in an travelling wave model of the transmission line. The method comprises carrying out, at certain specified time intervals, a measurement of the instantaneous values of the current and the voltage at the end point of the transmission line, for example in a station. With these measured values and with the aid of the travelling wave model, the voltage at a number of control points along the transmission line can then be calculated. If the transmission line is energized and the calculated control voltages at two consecutive control points constantly have different signs, then there must be fault on the transmission line between these points. Starting from the distance between the points in question and the calculated control voltages, the fault point can be located by interpolation.

It is the travelling wave model described in the afore-mentioned document that forms the basis for the fault location method according to the present invention.

The invention will now be described in greater detail with reference to the accompanying drawings showing - by way of example - in
- Figure 1: a power transmission line in faultless condition between two stations P and Q which are fed from two power sources A and B,
- Figure 2: the real voltage distribution along the transmission line in Figure 1 between the two power sources,
- Figure 3: the same voltage distribution, in which the voltage values have been calculated by means of a travelling wave model located at P or at Q, based on voltage and current values measured at P and Q,
- Figure 4: the same transmission line as in Figure 1 with a fault at F between P and Q,
- Figure 5: the measured voltage along the transmission line after the occurrence of a high resistance fault,
- Figure 6: the voltage difference ΔU along the transmission line between the measured or calculated voltage prior to a fault and the voltage calculated with a travelling wave model after a fault,
- Figure 7: the same power transmission line as in Figure 1 when a fault F has arisen between station P and power source A,
- Figure 8: the true or calculated voltage distribution along the line when a fault according to Figure 7 has occurred,
- Figure 9: the voltage differences ΔU along the line between the measured or calculated voltage prior to a fault and the voltage calculated with the travelling wave model after a fault according to Figure 7 has occurred,
- Figures 10 and 11: the vectorial relationship between the voltage differences,
- Figure 12: an embodiment of a device for fault location of a ground fault according to the invention when the complex impedances of the power sources and the transmission line have approximately equal arguments,
- Figure 13: an embodiment of a device for fault location of a ground fault according to the invention when the complex impedances of the power sources and the transmission line have arguments of different value,
- Figure 14: an embodiment according to the invention of a flow diagram for evaluation of auxiliary quantities ΔP and ΔQ for calculating the fault distance,
- Figure 15: an embodiment for evaluating the auxiliary quantities γₚ and γ_{q},
- Figure 16: an embodiment for evaluating the auxiliary quantities A, B and C,
- Figure 17: an embodiment for evaluating the auxiliary quantity δ,
- Figure 18: an embodiment for evaluating ΔP with the aid of auxiliary quantities produced, and
- Figure 19: an embodiment for evaluating ΔQ with the aid of auxiliary quantities produced.

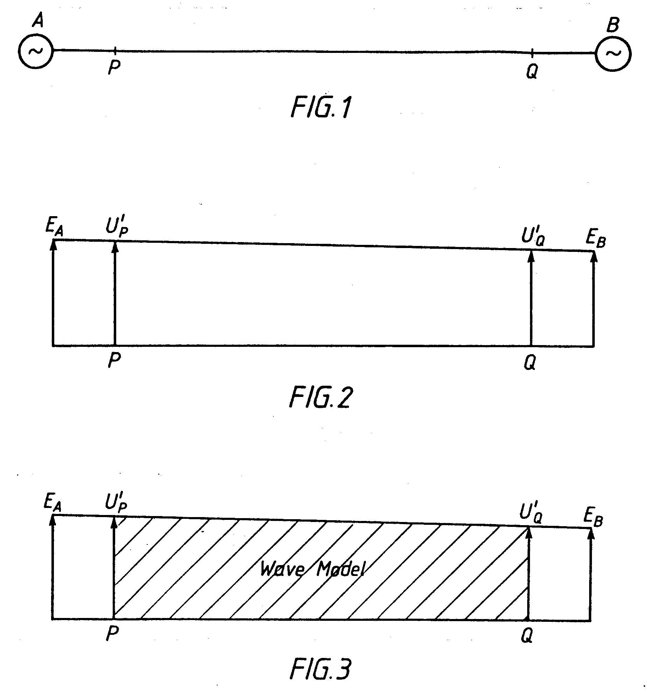

Figure 1 shows a power line between two stations or measuring points P and Q. In the example shown the line is fed from two power sources A and B.

Figure 2 shows the real voltage distribution along the line in a faultless state. E_{A} and E_{B}, respectively, are the E.M.F.s of the respective power sources, and U'_{P} and U'_{Q}, respectively, are the measured voltage at P and at Q, respectively.

In the above-mentioned EP-A-85107101.9, it is described how a travelling wave model of a transmission line can be used for calculating the voltage distribution along that line. With the aid of the current and voltage values measured in the station P and Q, it is therefore possible to measure, with the travelling wave model, the control voltages or the voltage distribution along the transmission line from station P towards station Q and from station Q towards station P, respectively in a faultless state (see Figure 3). This means that the same voltage distribution is obtained as in Figure 2 within the limits which are determined by errors in measurement in measuring transformers and by an uncertain knowledge of parameters.

In an ideal transmission system, the zero sequence voltage and the negative sequence voltage are zero under faultless conditions. In practice they can be assumed to be small. This applies particularly to that part of the zero sequence voltage and the negative sequence voltage which is caused by asymmetry in the monitored transmission line. The voltage change which occurs as a result of a fault may either be conceived to be the difference voltage ΔU which, in accordance with the theorem of Helmholtz-Th 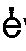 venin, arises at the different points of the networks as a result of the fault, or only the zero sequence component and the negative sequence component, respectively, of this change. The conclusions drawn are valid for all interpretations of ΔU. In the faultless case, thus, $\text{ΔU = O}$ at all measuring points.

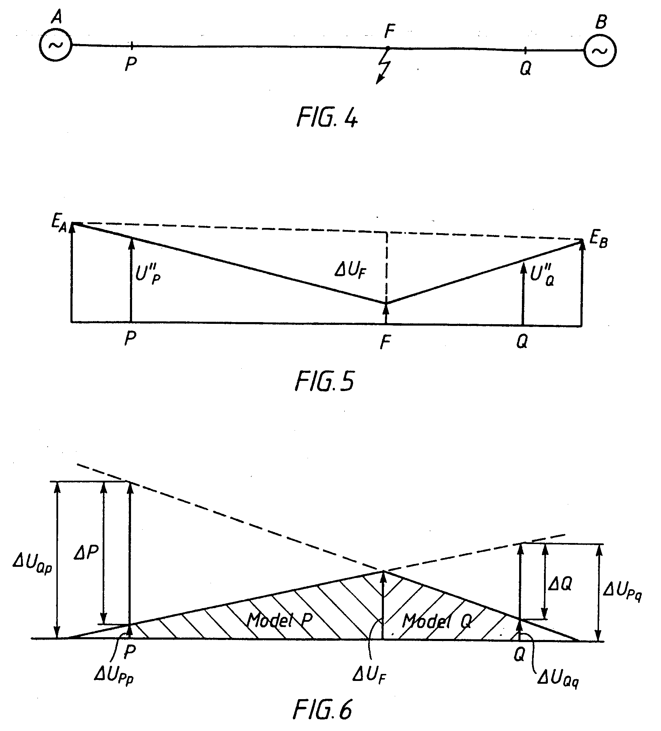

When the transmission line according to Figure 1 is subjected to an internal fault, that is, a fault located between the measuring points P and Q as indicated at F in Figure 4, a real voltage distribution is obtained according to Figure 5. The greatest voltage change ΔU_{F} occurs at the site of the fault F. The actual measured voltage at the points P and Q are now represented as U''_{P} and U''_{Q}.

In the following description the sign ' will indicate the values of quantities prior to the occurrence of a fault and the sign '' will indicate the values of quantities after the occurrence of a fault. Further, the following indexing system is used to define the quantities in question:
An index containing P indicates that the quantity in question has been calculated with values measured at the measuring point P.

An index containing Q indicates that the quantity in question has been calculated with values measured at the measuring point Q.

An index containing p indicates that the value of the quantity in question is calculated for the point P.

An index containing q indicates that the value of the quantity in question is calculated for the point Q.

This means, for example, that U_{Pq} indicates a voltage at Q calculated with values measured at P.

With the aid of this system, the following difference voltages will now be defined:

${\text{ΔU}}_{\text{Pp}} {\text{= U'}}_{\text{P}} {\text{- U''}}_{\text{P}} \text{(1)}$

${\text{ΔU}}_{\text{Qq}} {\text{= U'}}_{\text{Q}} {\text{- U''}}_{\text{Q}} \text{(2)}$

${\text{ΔU}}_{\text{Pq}} {\text{= U'}}_{\text{Pq}} {\text{- U''}}_{\text{Pq}} \text{(3)}$

${\text{ΔU}}_{\text{Qp}} {\text{= U'}}_{\text{Qp}} {\text{- U''}}_{\text{Qp}} \text{(4)}$

The zero sequence component in the changes is obtained by forming the sum of the phase voltages U'_{R}, U'_{S} and U'_{T}. Prior to occurrence of a fault ${\text{U''}}_{\text{R}} {\text{+ U''}}_{\text{S}} {\text{+ U''}}_{\text{T}} \text{= O}$ , and a simple calculation of ${\text{(ΔU}}_{\text{Pp}} {\text{)}}_{\text{O}}$ , ${\text{(ΔU}}_{\text{Qq}} {\text{)}}_{\text{O}}$ , ${\text{(ΔU}}_{\text{Pq}} {\text{)}}_{\text{O}}$ and ${\text{(ΔU}}_{\text{Qp}} {\text{)}}_{\text{O}}$ in all the cases is obtained as

${\text{(ΔU)}}_{\text{O}} {\text{= U'}}_{\text{O}} {\text{= U'}}_{\text{R}} {\text{+ U'}}_{\text{S}} {\text{+ U'}}_{\text{T}} \text{.}$

The negative sequence component can be obtained by means of some known type of negative sequence filter.

In Figure 6 the voltage differences according to equations (1), (2), (3) and (4) are plotted graphically. It can be determined that a device at P for calculating the voltage distribution from P towards Q has a line model which is correct between P and F but incorrect at point F, and therefore the calculated voltage distribution is incorrect for the distance FQ. In similar manner, a device at Q provides a correct picture of the voltage distribution between Q and F but an incorrect picture of the voltage distribution between F and P. The two devices together gives a correct distribution of the voltage namely the device at P for the distance PF and the device at Q for the distance QF. F is the only point for which the two devices give the same model voltage.

The voltage differences ΔP and ΔQ, as they are represented in Figure 6, that is,

${\text{ΔP = ΔU}}_{\text{Qp}} {\text{- ΔU}}_{\text{Pp}} \text{(5)}$

${\text{ΔQ = ΔU}}_{\text{Pq}} {\text{- ΔU}}_{\text{Qq}} \text{(6)}$

can now be utilized for ground fault indication, since in a faultless state both ΔP and ΔQ are zero. ΔP constitutes an error in measurement at Q concerning the voltage change at P, and ΔQ constitutes an error in measurement at P concerning the voltage at Q because the wave models in the case of a fault at F are not correct for the whole transmission line. ΔP and ΔQ can therefore be referred to as model fault voltages which are always zero if the real transmission line and the model are in agreement.

For calculating ΔP and ΔQ in equations (5) and (6), the mean value, the R.M.S. or the peak value of the difference voltage can be utilized.

The method and the equipment for fault location according to the invention are based on an evaluation of the model fault voltages ΔP and ΔQ. The presents ΔP and ΔQ indicate that a fault has occurred. On the basis of the geometry in Figure 6, the fault can be located in a simple manner. IF the distance between P and Q is designated PQ, the fault distance from P to the fault point F can be calculated as follows: 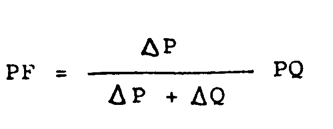
With the aid of the voltage differences described, a fault located behind a measuring point can also be detected in a simple manner. In the case of measuring point P, a fault located behind the measuring point relates to a fault between the power source A and the point P, and in the case of measuring point Q a fault located behind the measuring point relates to a fault between the power source B and the point Q.

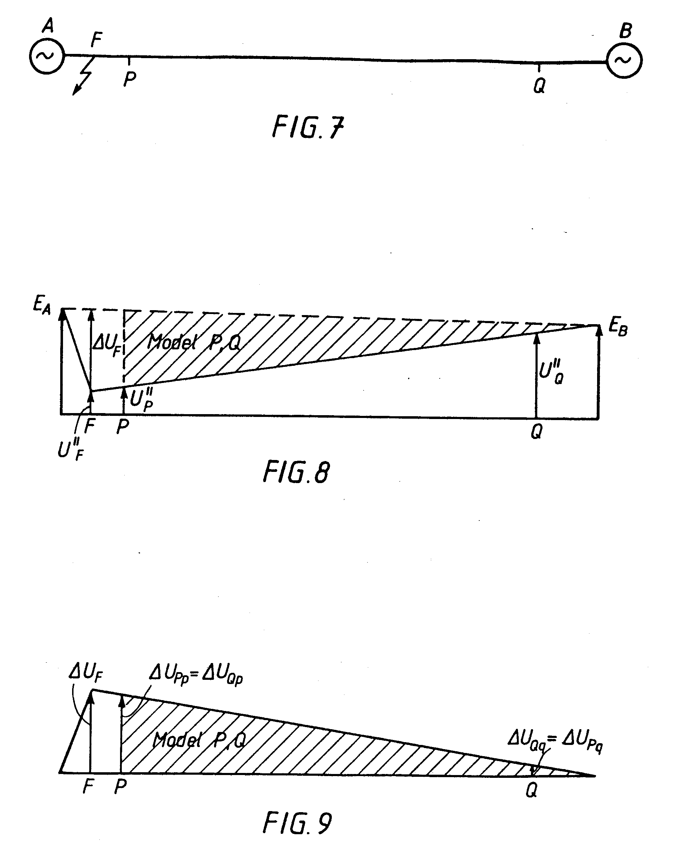

If a fault occurs between A and P according to Figure 7, a real voltage distribution is obtained according to Figure 8. The distribution of the voltage difference between P and Q, calculated with the travelling wave model, is clear from Figure 9. It can be seen that the protection devices at P and Q provide the same voltage distribution for the whole transmission line, which means that for a fault located be-hind the measuring point in question the following relationships apply

${\text{|ΔU}}_{\text{Pq}} {\text{|-|ΔU}}_{\text{Qp}} \text{|= O (8)}$

${\text{|ΔU}}_{\text{Qp}} {\text{|-|ΔU}}_{\text{Pp}} \text{|= O (9)}$

It can also be shown in a simple manner that equations (8) and (9) must be valid for a fault between B and Q. Distinguishing for a fault between A and P and a fault between B and Q, is then that for a fault between A and P

${\text{|ΔU}}_{\text{Pq}} {\text{|-|ΔU}}_{\text{Pp}} \text{|< O (10)}$

and for a fault between B and Q

${\text{|ΔU}}_{\text{Pq}} {\text{|-|ΔU}}_{\text{Pp}} \text{|> O (11)}$

In the figures the distribution of the difference voltages along the transmission line are drawn as straight lines. It can be proved that this is true since the difference in argument for the complex impedances of the power sources and the line is small. This is a prerequisite for the fault location equation (7) which, however, gives good results also in the case of normal differences between the arguments of the sources and the line. This means that, if the arguments are not too different, only two calculated values from station Q, namely ΔU_{Qq} and ΔU_{Qp}, need be transferred to station P.

A general and exact calculation method with arbitrary source impedances presupposes that three quantities are transferred via the data communication link which a constantly switched-in fault locator requires. The basis for the general case will he described below. The description is based on stationary conditions, that is, with complex currents and voltages. ΔI is defined as the stationary fault current which is superposed on the condition prevailing prior to the occurrence of the fault and constitutes the current flowing at the fault point. This current is distributed such that
${\text{K}}_{\text{1P}} {\text{ΔI₁ = ΔI}}_{\text{1P}}$ is the positive sequence component
${\text{K}}_{\text{2P}} {\text{ΔI₂ = ΔI}}_{\text{2P}}$ is the negative sequence component and
${\text{K}}_{\text{OP}} {\text{ΔI}}_{\text{O}} {\text{= ΔI}}_{\text{OP}}$ is the zero sequence component
of the current at the measuring point P. K is the distribution factor for the respective component of the current at the fault point.

Z_{1A}, Z_{2A}, Z_{OA} are source impedances seen from the measuring point P of the protection equipment.

Z₁ and Z_{O} are the impedances (Z₂ = Z₁) of the transmission line for the distance PQ.

U' is the voltage prevailing at the measuring point prior to a fault.

A single-phase ground fault in phase R is assumed to occur on the transmission line.

In this case applies ΔI₁ = ΔI₂ = ΔI_{O} = ΔI. For each phase the control voltages of the measuring point, after the occurrence of a fault, can be expressed as follows:

${\text{U}}_{\text{RPp}} {\text{= U'}}_{\text{RPp}} {\text{- ΔI (K}}_{\text{1P}} {\text{Z}}_{\text{1A}} {\text{+ K}}_{\text{2P}} {\text{Z}}_{\text{2A}} {\text{+ K}}_{\text{OP}} {\text{Z}}_{\text{OA}} \text{) (12)}$

${\text{U}}_{\text{SPp}} {\text{= U'}}_{\text{SPp}} {\text{- ΔI (a²K}}_{\text{1P}} {\text{Z}}_{\text{1A}} {\text{+ aK}}_{\text{2P}} {\text{Z}}_{\text{2A}} {\text{+ K}}_{\text{OP}} {\text{Z}}_{\text{OA}} \text{) (13)}$

${\text{U}}_{\text{TPp}} {\text{= U'}}_{\text{TPp}} {\text{- ΔI (aK}}_{\text{1P}} {\text{Z}}_{\text{1A}} {\text{+ a²K}}_{\text{2P}} {\text{Z}}_{\text{2A}} {\text{+ K}}_{\text{OP}} {\text{Z}}_{\text{OA}} \text{) (14)}$

The calculated control voltages for the remote end point are as follows:

${\text{U}}_{\text{RPq}} {\text{= U'}}_{\text{RPq}} {\text{- ΔI [K}}_{\text{1P}} {\text{(Z}}_{\text{1A}} {\text{+ Z₁) + K}}_{\text{2P}} {\text{(Z}}_{\text{2A}} {\text{+ Z₁) + K}}_{\text{OP}} {\text{(Z}}_{\text{OA}} {\text{+ Z}}_{\text{O}} \text{)] (15)}$

${\text{U}}_{\text{SPq}} {\text{= U'}}_{\text{SPq}} {\text{- ΔI [a²K}}_{\text{1P}} {\text{(Z}}_{\text{1A}} {\text{+ Z₁) + aK}}_{\text{2P}} {\text{(Z}}_{\text{2A}} {\text{+ Z₁) + K}}_{\text{OP}} {\text{(Z}}_{\text{OA}} {\text{+ Z}}_{\text{O}} \text{)] (16)}$

${\text{U}}_{\text{TPq}} {\text{= U'}}_{\text{TPq}} {\text{- ΔI [aK}}_{\text{1P}} {\text{(Z}}_{\text{1A}} {\text{+ Z₁) + a²K}}_{\text{2P}} {\text{(Z}}_{\text{2A}} {\text{+ Z₁) + K}}_{\text{OP}} {\text{(Z}}_{\text{OA}} {\text{+ A}}_{\text{O}} \text{)] (17)}$

During the filtration in order to obtain the voltage change, U' disappears and for the first period or half-period after the occurrence of a fault, depending on how the filtration is performed, the following relationships are valid:

${\text{ΔU}}_{\text{RPp}} {\text{= - ΔI (K}}_{\text{1P}} {\text{Z}}_{\text{1A}} {\text{+ K}}_{\text{2P}} {\text{Z}}_{\text{2A}} {\text{+ K}}_{\text{OP}} {\text{Z}}_{\text{OA}} \text{) (18)}$

${\text{ΔU}}_{\text{SPp}} {\text{= - ΔI (a²K}}_{\text{1P}} {\text{Z}}_{\text{1A}} {\text{+ aK}}_{\text{2P}} {\text{Z}}_{\text{2A}} {\text{+ K}}_{\text{OP}} {\text{Z}}_{\text{OA}} \text{) (19)}$

${\text{ΔU}}_{\text{TPp}} {\text{= - ΔI (aK}}_{\text{1P}} {\text{Z}}_{\text{1A}} {\text{+ a²K}}_{\text{2P}} {\text{Z}}_{\text{2A}} {\text{+ K}}_{\text{OP}} {\text{Z}}_{\text{OA}} \text{) (20)}$

and

${\text{ΔU}}_{\text{RPq}} {\text{= - ΔI [(K}}_{\text{1P}} {\text{(Z}}_{\text{1A}} {\text{+ Z₁) + K}}_{\text{2P}} {\text{(Z}}_{\text{2A}} {\text{+ Z₁) + K}}_{\text{OP}} {\text{(Z₂₀ + Z}}_{\text{O}} \text{)] (21)}$

${\text{ΔU}}_{\text{SPq}} {\text{= - ΔI [(a²K}}_{\text{1P}} {\text{(Z}}_{\text{1A}} {\text{+ Z₁) + aK}}_{\text{2P}} {\text{(Z}}_{\text{2A}} {\text{+ Z₁) + K}}_{\text{OP}} {\text{(Z}}_{\text{OA}} {\text{+ Z}}_{\text{O}} \text{)] (22)}$

${\text{ΔU}}_{\text{TPq}} {\text{= - ΔI [(aK}}_{\text{1P}} {\text{(Z}}_{\text{1A}} {\text{+ Z₁) + a²K}}_{\text{2P}} {\text{(Z}}_{\text{2A}} {\text{+ Z₁) + K}}_{\text{OP}} {\text{(Z}}_{\text{OA}} {\text{+ Z}}_{\text{O}} \text{)] (23)}$

The zero sequence change, that is, one-third of the sum voltage, and also the negative sequence change are of special interest to ground fault detection. Since ${\text{U}}_{\text{O}} \text{= O}$ may be assumed to be valid prior to a fault, its occurrence implies that there is a fault in the network. Thus, in addition to the generation of the sum of the phase voltages, no special filtering to obtain ΔU_{O} is needed, and ${\text{ΔU}}_{\text{O}} \text{= O}$ prior to a fault, If ${\text{K}}_{\text{OP}} {\text{ΔI = ΔI}}_{\text{OP}}$ 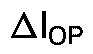 is used, the sum voltage can be expressed as: 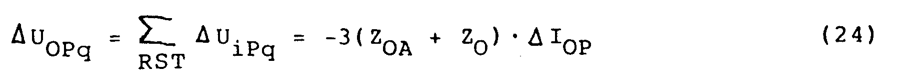
and 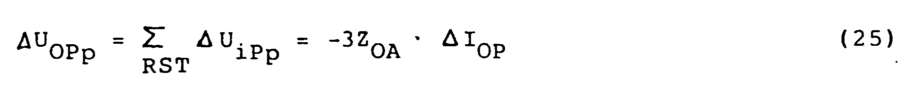
For the actual fault point, if the zero sequence impedance of PF is designated Z_{OPF}, the following sum voltage can be calculated: 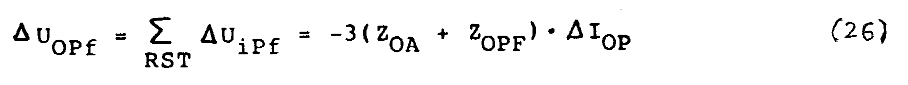
If the corresponding calculations are made for a protection device at Q, the following relationships are obtained: 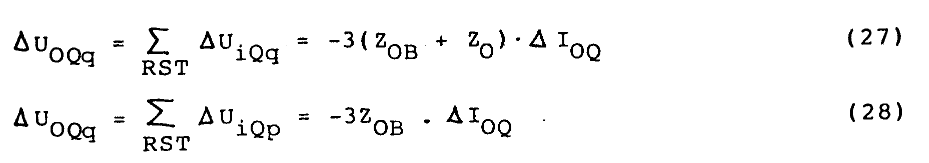
and 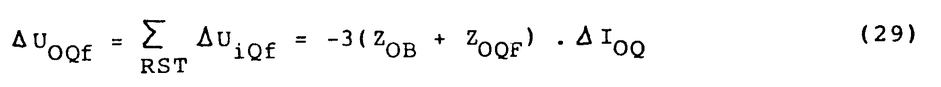
It is also possible to write:

${\text{ΔU}}_{\text{OPq}} {\text{= -3(Z}}_{\text{OA}} {\text{+ Z}}_{\text{OPF}} {\text{)ΔI}}_{\text{OP}} {\text{- 3Z}}_{\text{OQF}} {\text{. ΔI}}_{\text{OP}} {\text{= ΔU}}_{\text{OPf}} {\text{- 3Z}}_{\text{OQF}} {\text{· ·ΔI}}_{\text{OP}} \text{(30)}$

${\text{U}}_{\text{OPp}} {\text{= -3(Z}}_{\text{OA}} {\text{+ Z}}_{\text{OPF}} {\text{)ΔI}}_{\text{OP}} {\text{+ 3Z}}_{\text{OPF}} {\text{. ΔI}}_{\text{OP}} {\text{= ΔU}}_{\text{OPf}} {\text{+ 3Z}}_{\text{OPF}} {\text{· ·ΔI}}_{\text{OP}} \text{(31)}$

and since ${\text{ΔU}}_{\text{OPf}} {\text{= ΔU}}_{\text{OQf}}$ , the following relationships are obtained:

${\text{ΔU}}_{\text{OQp}} {\text{=ΔU}}_{\text{OPf}} {\text{= - 3Z}}_{\text{OPF}} {\text{· ΔI}}_{\text{OQ}} \text{(32)}$

and

${\text{ΔU}}_{\text{OQq}} {\text{= ΔU}}_{\text{OPf}} {\text{= + 3Z}}_{\text{OQF}} {\text{· ΔI}}_{\text{OQ}} \text{(33)}$

By inserting the following equations

${\text{ΔP}}_{\text{O}} {\text{= ΔU}}_{\text{OQp}} {\text{- ΔU}}_{\text{OPp}} \text{(34)}$

${\text{ΔQ}}_{\text{O}} {\text{= ΔU}}_{\text{OPq}} {\text{- ΔU}}_{\text{OQq}} \text{(35)}$

the equations 30-33 yield 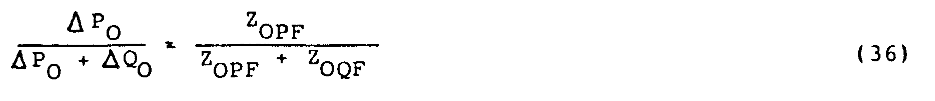
It can be noted that ΔP_{O} and ΔQ_{O} have the same arguments, since the impedance quotient in the righthand term of equation (36) is real. Z_{OPF} and Z_{OQF} have the same arguments since they are parts of the same line PQ. Given the simplified assumption that the complex impedances in the source and the line have the same arguments, the voltages ΔU_{OQp}, ΔU_{OPq} and ΔU_{OQq} will have the same phase angle, and the simplified calculation with mean values according to equations (5) to (7) can be used. This makes it possible to limit the data transmission to two mean values |ΔU_{Qq}| and |ΔU_{Qp}| from station Q to station P in order to evaluate the fault position on the transmission line as described above. What is further required in the general case for an exact determination is another measured value for determining the phase angle γ_{q} between ΔU_{Qp} and ΔU_{Qq}.

The problem in the general case with arbitrary source impedances is that the mutual phase difference between the partial voltages at ΔP and ΔQ have to be determined before the amounts of ΔP and ΔQ can be determined. A general method, independent of the arguments of the source impedances, is obtained if, in addition to the above-mentioned calculated end point voltages, also the difference voltages according to the below are utilized. The method then only uses peak values or mean values.

${\text{ΔU}}_{\text{OPpq}} {\text{= ΔU}}_{\text{OPq}} {\text{- ΔU}}_{\text{OPp}} \text{(37)}$

${\text{ΔU}}_{\text{OQqp}} {\text{= ΔU}}_{\text{OQp}} {\text{- ΔU}}_{\text{OQq}} \text{(38)}$

This exact determination thus presupposes, as previously described, that three quantities be transmitted via the data communications link which is required by a constantly switched-in fault locator.

If, in order to simplify quantity designations and indexes for quantities locally calculated at P, the following equations are inserted

${\text{|ΔU}}_{\text{OPp}} {\text{|= a}}_{\text{p}} \text{(39)}$

${\text{|ΔU}}_{\text{OPq}} {\text{|= b}}_{\text{p}} \text{(40)}$

${\text{|ΔU}}_{\text{OPpq}} {\text{|= c}}_{\text{p}} \text{(41)}$

and if for quantities locally calculated at Q, the following equations are inserted

${\text{|ΔU}}_{\text{OQq}} {\text{|= a}}_{\text{q}} \text{(42)}$

${\text{|ΔU}}_{\text{OQp}} {\text{|= b}}_{\text{q}} \text{(43)}$

${\text{|ΔU}}_{\text{OQqp}} \text{|= cq (44)}$

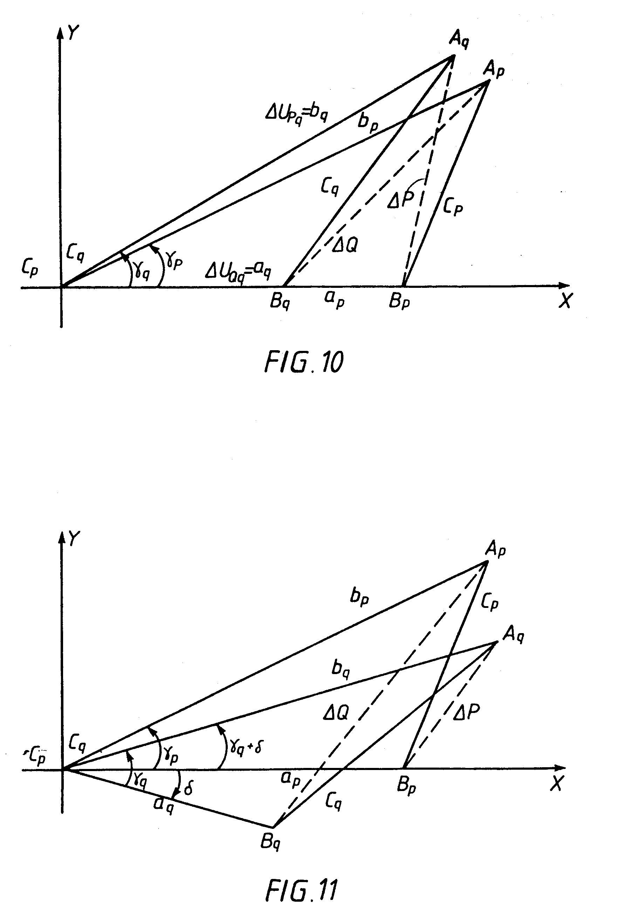

it will be clear from the vectorial relationship in Figures 10 and 11 that a, b and c constitute sides in triangles having corners Cₚ, Bₚ, Aₚ and C_{q}, B_{q}, A_{q}, respectively, where the triangles have been placed in a right-angled xy-coordinates system with Cₚ and C_{q} at the origin of coordinates and with the sides CₚBₚ and C_{q}B_{q} along the x-axis. Since all the sides in the triangles are known, it is possible to determine all the angles in the triangles with the aid of the cosine theorem. Especially the angles γₚ and γ_{q}, respectively, are determined from the equation 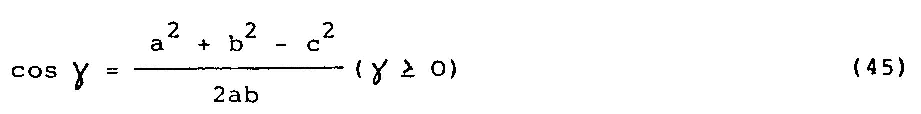
From Figure 10 the significance of ΔP and ΔQ is also clear. However, as has been shown in equation (36), in order to obtain correct ΔP and ΔQ values these must have the same arguments, that is, they must be parallel. For example, by turning the triangle C_{q}B_{q}A_{q} through an angle δ so that ΔP and ΔQ become parallel, correct values of these quantities are obtained, which will be clear from Figure 11.

For the corners A_{q}, Bₚ, Aₚ and B_{q} in Figure 11, the following coordinates are valid:

${\text{A}}_{\text{q}} {\text{: [b}}_{\text{q}} {\text{cos(γ}}_{\text{q}} {\text{+ δ) ; b}}_{\text{q}} {\text{sin(γ}}_{\text{q}} \text{+ δ )]}$
${\text{B}}_{\text{p}} {\text{: [a}}_{\text{p}} \text{; O]}$
${\text{A}}_{\text{p}} {\text{: [b}}_{\text{p}} {\text{cos(γ}}_{\text{p}} {\text{) ; b}}_{\text{p}} {\text{sin(γ}}_{\text{p}} \text{)]}$
${\text{B}}_{\text{q}} {\text{: [a}}_{\text{q}} {\text{cos (δ) ; a}}_{\text{q}} \text{sin(δ)]}$

The condition ΔP parallel to ΔQ can be expressed as follows: 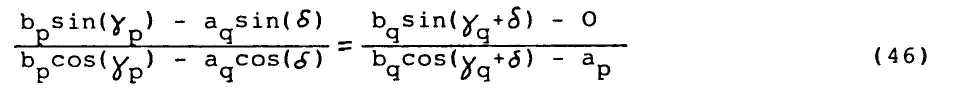
From this equation the angle δ can be solved, whereafter the coordinates for the corners of the triangles can be determined and the amounts ΔP and ΔQ be calculated.

With

${\text{A = b}}_{\text{p}} {\text{b}}_{\text{q}} {\text{sin(γ}}_{\text{p}} {\text{-γ}}_{\text{q}} \text{) (47)}$

${\text{B = a}}_{\text{p}} {\text{a}}_{\text{q}} {\text{- b}}_{\text{p}} {\text{b}}_{\text{q}} {\text{cos(γ}}_{\text{p}} {\text{-γ}}_{\text{q}} \text{) (48)}$

and

${\text{C = a}}_{\text{q}} {\text{b}}_{\text{q}} {\text{sinγ}}_{\text{q}} {\text{- a}}_{\text{p}} {\text{b}}_{\text{p}} {\text{sinγ}}_{\text{p}} \text{(49)}$

equation (45) can be expressed as follows:

$\text{A cos δ + B sin δ + C = O (50)}$

This equation is simplified further and the following quadratic equation is obtained:

$\text{(C-A)tan²} \frac{\text{δ}}{\text{2}} \text{+ (2B)tan} \frac{\text{δ}}{\text{2}} \text{+ (A+C) = O (51)}$

with the solutions (if $\text{A²+B²-C² ≧ O}$ and $\text{A-C ≠ O}$ ) 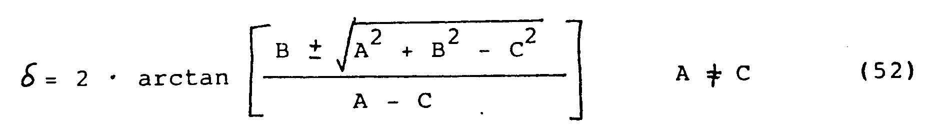
Of the two solutions the solution which gives the vectors BₚA_{q} and B_{q}Aₚ opposite directions is rejected. The solution shall fulfill the condition:

${\text{[b}}_{\text{q}} {\text{cos(γ}}_{\text{q}} {\text{+δ)-a}}_{\text{p}} {\text{]·[b}}_{\text{p}} {\text{cosγ}}_{\text{p}} {\text{-a}}_{\text{q}} \text{cosδ)] ≧ O (53)}$

and

${\text{[b}}_{\text{q}} {\text{sin(γ}}_{\text{q}} {\text{+δ)]·[b}}_{\text{p}} {\text{sinγ}}_{\text{p}} {\text{-a}}_{\text{q}} \text{sinδ)] ≧ O (54)}$

ΔP and ΔQ can be calculated with the distance formula from the analytical geometry: 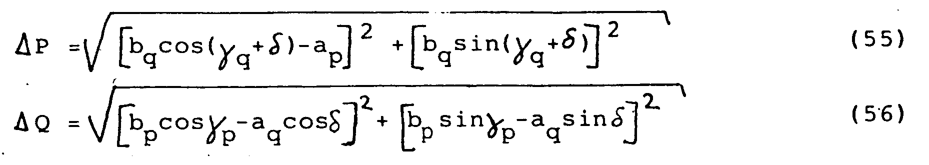
The fault distance PQ can then be calculated according to equation (7).

Since the mathematical model for calculating control voltages or the voltage distribution along the transmission line is a correct and accurate method within the limits determined by errors in measurement and the like, this also means a high accuracy in the fault location.

As stated above, the complete travelling wave model gives control voltages along the entire transmission line. However, as will have been clear from the disclosure of the invention, what is needed for the fault location is really only access to control voltages at the two end points calculated with measured values for the respective opposite end point on the protected transmission line, in addition to a communication link between P and Q. This means that it is also possible to use a simplified version of the travelling wave model and that the equipment for carrying out the method according to the invention will therefore be a considerably simpler than if a complete voltage distribution has to be obtained.

The method and the equipment according to the invention can be applied to principal voltages, phase voltages as well as zero sequence and negative sequence voltages.

As will be clear from the description of the method for fault location of a fault point, the starting-point are the same model fault voltages ΔP and ΔQ as are used for detection of a ground fault. In addition to comprising members for the actual evaluation of the fault distance between one of the stations and the fault point, a device for fault detection therefore comprises necessary members for generating the voltage differences ΔP and ΔQ.

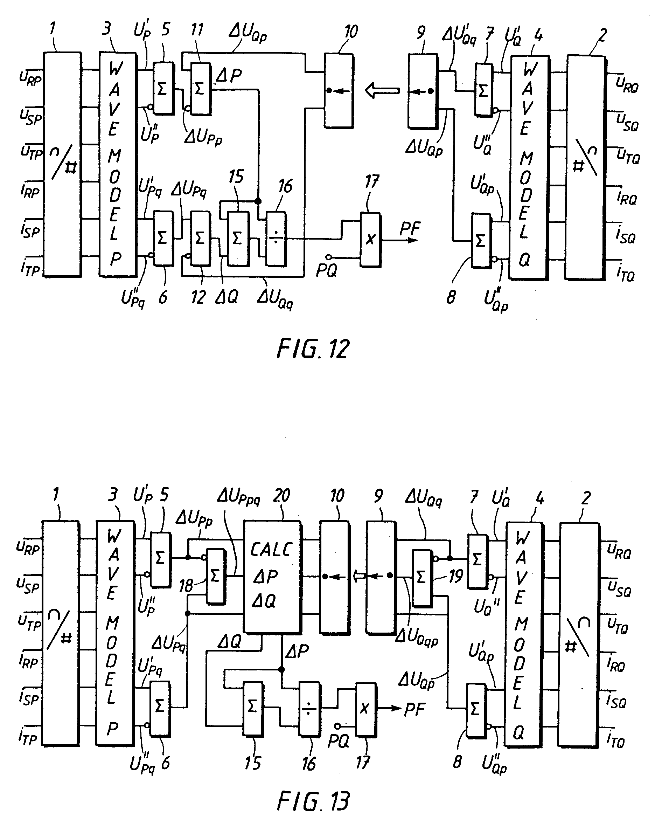

An embodiment for equipment to carry out the method according to the invention in those cases where it can be assumed that the arguments for the complex impedances of the power sources and the transmission line are close to each other, is shown in Figure 12. As will be clear from the above, this assumption permits the transmission of only two values from one station to the other.

Voltages u_{RP}, u_{SP}, u_{TP} and currents i_{RP}, i_{SP}, i_{TP}, measured in analog manner in station P are converted to digital signals in the measured value convertor 1. The corresponding conversion of measured values in station Q is performed in the convertor 2. The digital measured values are each supplied to a respective digital travelling wave model 3 and 4.

As will be clear from the above description of the method, the fault detection can take place with the aid of a phase voltage, a principal voltage, a zero sequence voltage or a negative sequence voltage. Thus, the voltage values U delivered from the travelling wave model can be anyone of the afore-mentioned voltages; however, the choice of the kind voltage must be the same for all voltage values, for example all values U must be principal voltages.

The value of U''_{P}, which may be a mean value of the voltage in question during one period, is compared in the summator 5 with U'_{P}, that is, the mean value of the same voltage measured for the preceding period or half-period. In stationary and faultless state, the difference ΔU_{Pp} is zero. When a new measured value for the next period or half-period becomes available, an existing U''_{P} is transferred into a new U'_{P} and the new measured value forms a new U''_{P}. This shifting and updating takes place continuously up to the point where a fault occurs, whereby ΔU_{Pp} receives a new value different from zero.

With the aid of voltage and current values measured at P, the voltage U''_{Pq}, that is, the voltage in station Q, can be calculated with the travelling wave model. In similar manner, the value of U'_{Pq}, that is, the value one period or one half period earlier, can be calculated. These two values are compared with each other in the summator 6, whereby the difference or sum ΔP_{Pq} is generated.

To execute the equations (5) and (6), that is, to form the differences ΔP and ΔQ, the values of ΔU_{Qq} and ΔU_{Qp} must be transferred to station P. This transfer takes place by means of a transmitter 9 in station Q and a receiver 10 in station P. Of course, the execution may instead take place in station Q, whereby the values of ΔU_{Pp} and ΔU_{Pq} must be transferred in a respective manner from station P to station Q.

The value of the model fault voltage ΔP is now generated according to equation (5) in a summator 11 and the corresponding value of ΔQ is generated in the summator 12. According to the description of the method for the fault location, it is possible, with access to the values of ΔP and ΔQ and knowledge of the length PQ of the protected transmission line, to determine the distance between station P and the fault point according to equation (7).

The sum of ΔP and ΔQ is formed in summator 15. ΔP is then divided by the sum of ΔP and ΔQ, that is, by the outcome of the summator 15, in the division element 16. By multiplying, in a multiplier 17, the quotient generated in element 16 by the length PQ of the transmission line, a measure of the distance PF between station P and the fault point F is obtained.

If the arguments for the impedance of the sources are different from each other to such a degree that the general method for obtaining ΔP and ΔQ, described above, must be employed, three values must be transferred from one station to the other, as mentioned above. If the evaluation of ΔP and ΔQ is to take place in station P, it is the voltage differences in the Q station, that is, the values according to equations (42), (43) and (44) that are to be transferred to station P.

The description of the method according to the invention for the evaluation of ΔP and ΔQ in the general case has been based on the zero sequence voltage change according to equations (25) to (56). As also mentioned above, in addition to zero sequence voltages, the evaluation is also valid for negative sequence voltages, phase voltages and principal voltages. In order to show that any one of these voltage differences can he used, in the description of an embodiment of the general method all references to zero sequence voltage, negative sequence voltage, phase voltage or principal voltage have been omitted. This means that the embodiment will be described by the following equations:

${\text{|ΔU}}_{\text{Pp}} {\text{| = |U'}}_{\text{P}} {\text{- U''}}_{\text{P}} {\text{| = a}}_{\text{p}} \text{(1)}$

${\text{|ΔU}}_{\text{Qq}} {\text{| = |U'}}_{\text{Q}} {\text{- U''}}_{\text{Q}} {\text{| = a}}_{\text{q}} \text{(2)}$

${\text{|ΔU}}_{\text{Pq}} {\text{| = |U'}}_{\text{Pq}} {\text{- U''}}_{\text{Pq}} {\text{| = b}}_{\text{p}} \text{(3)}$

${\text{|ΔU}}_{\text{Qp}} {\text{| = |U'}}_{\text{Qp}} {\text{- U''}}_{\text{Qp}} {\text{| = b}}_{\text{q}} \text{(4)}$

${\text{|ΔU}}_{\text{Ppq}} {\text{| = |ΔU}}_{\text{Pq}} {\text{- ΔU}}_{\text{Pp}} {\text{| = c}}_{\text{p}} \text{(57)}$

${\text{|ΔU}}_{\text{Qqp}} {\text{| = |ΔU}}_{\text{Qp}} {\text{- ΔU}}_{\text{Qq}} {\text{| = c}}_{\text{q}} \text{(58)}$

The embodiment refers to Figure 12 and is supplemented by summator devices 18 and 19 for generating cₚ and c_{q} according to the above description. Transmitter 9 and receiver 10 now transmit three measured values a_{q}, b_{q} and c_{q}, which together with aₚ, bₚ and cₚ are supplied to a calculator 20 for evaluating ΔP and ΔQ. The calculation of the fault distance PF then takes place in the same way as according to Figure 12.

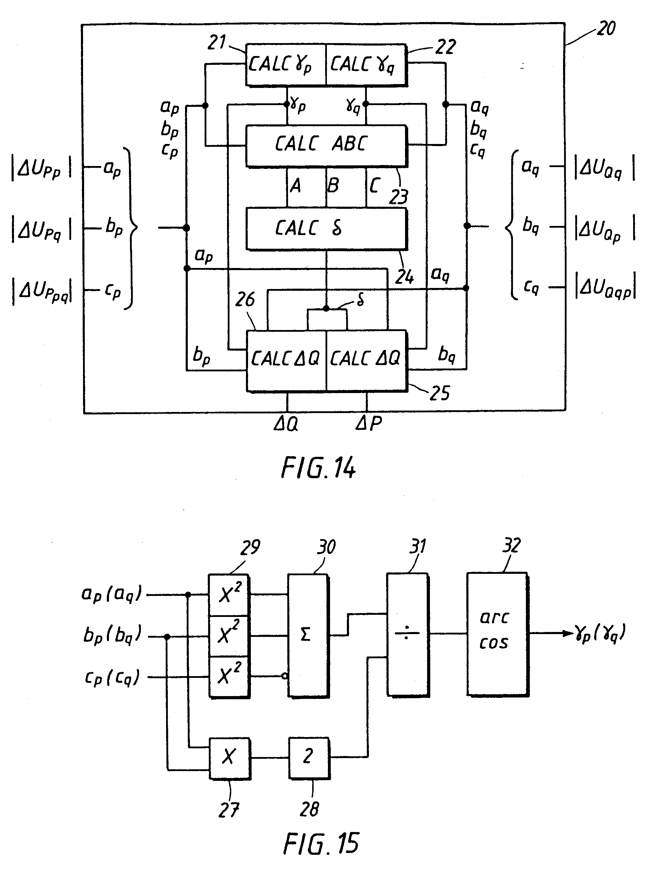

Figure 14 shows a flow diagram for the calculator 20. It includes devices 21 and 22 for calculating γₚ and γ_{q}, device 23 for calculating the auxiliary quantities A, B and C, device 24 for calculating δ, devices 25 and 26 for final calculation of ΔP and ΔQ.

The calculating devices 21-26 comprise simple mathematical operations which can be carried out in many different ways. In principle, the calculating devices 21 and 26 for calculating γₚ and γ_{q} according to equation (44) can be designed according to Figure 15 with multipliers 27 and 28, elements for squaring, 29, for summation, 30, for division, 31, and a unit 32 (arccos) for generating the angle by the arccosine function.

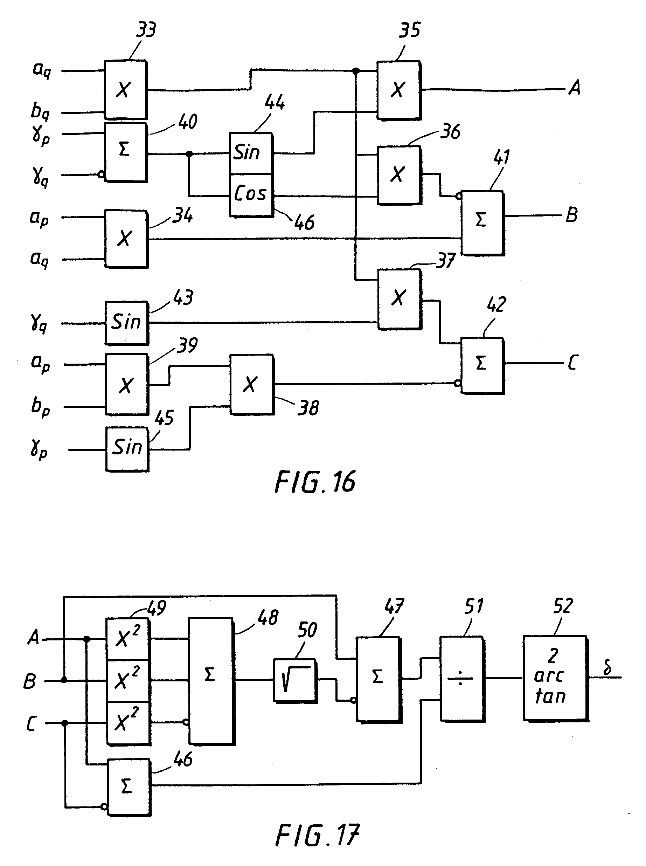

The device 23 for calculating the auxiliary quantities A, B and C according to equations (47), (48) and (49) may, in principle, be designed according to Figure 16 comprising multipliers 33 to 39, summation devices 40, 41 and 42, elements 43, 44 and 46 for sine generation and element 46 for cosine generation.

The device 24 for calculating the angle δ according to equation (52) can be designed as shown in Figure 17 comprising elements for summation, 46, 47, 48, for squaring, 49, for generating the square root, 50, for division, 51, and for generating the angle by the arctan function, 52.

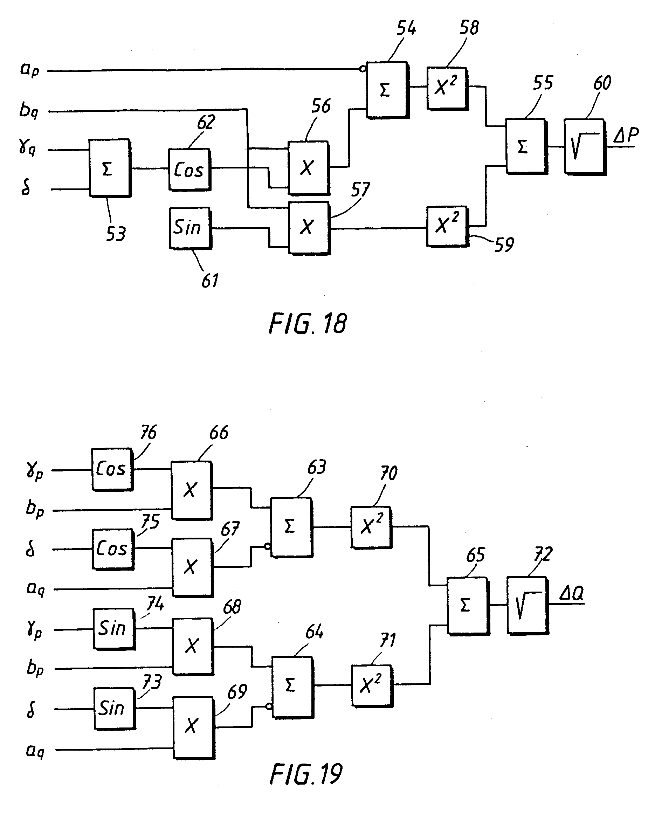

The device 25 for calculating ΔP according to equation (55) can be designed according to Figure 18 comprising elements for summation, 53, 54 and 55, for multiplying, 56, 57, for squaring, 58, 59, for extracting the square root, 60, and elements for sine generation, 61, and cosine generation, 62.

The device 26 for calculating ΔQ according to equation (56) can be designed according to Figure 19 comprising elements for summation, 63, 64, 65, for multiplying, 66, 67, 68, 69, for squaring, 70, 71, for extracting the square root, 72, and elements for sine generation, 73, 74, and cosine generation, 75, 76.

In the embodiment of the fault locating equipment which assumes approximately equal arguments for source impedances and line impedances as well as in the embodiment according to the general alternative as regards arguments, the components included, such as analog-digital convertors, travelling wave model, summator, comparison device, etc. can of course be designed as more or less integrated solutions in modern analog or digital technique.

As stated in the description of the method, alternative solutions to both alternative versions can be formed with a complete travelling wave model with the aid of which the voltage distribution along the whole transmission line between P and Q can be obtained, or with a simplified model which only gives the control voltage in the respective opposite station.

## Claims

1. Method for locating a fault on a power line located between a first (P) and a second (Q) station , which line is included in a multi-phase distribution or transmission system, with measurement of the instantaneous values of the current and the voltage in each phase at the two end points (P, Q) of the transmission line, with converting the measured values into corresponding digital values, which are then supplied to a travelling wave model (2, 3) in the respective station, and with obtaining the voltage distribution along the transmission line, seen both from station P to station Q and from station Q to station P, with the aid of the travelling wave models, wherein
${\text{a}}_{\text{p}} {\text{=|ΔU}}_{\text{Pp}} \text{|}$ is formed as the difference between the voltage U'_{P}, measured in the first station (P) or calculated by means of the travelling wave model, and the corresponding voltage U''_{P} one period or one half-period later,
${\text{a}}_{\text{q}} {\text{=|ΔU}}_{\text{Qq}} \text{|}$ is formed as the difference between the voltage U'_{Q}, measured in the second station (Q) or calculated by means of the travelling wave model, and the corresponding voltage U''_{Q} one period or one half-period later,
${\text{b}}_{\text{p}} {\text{=|ΔU}}_{\text{Pq}} \text{|}$ is formed as the difference between the voltage U'_{Pq} in the second station (Q), calculated in the travelling wave model in the first station (P) with values of currents and voltages measured in the first station, and the corresponding voltage U''_{Pq} one period or one half-period later,
${\text{b}}_{\text{q}} {\text{=|ΔU}}_{\text{Qp}} \text{|}$ is formed as the difference between the voltage U'_{Qp} in the first station (P), calculated in the travelling wave model in the second station (Q) with values of currents and voltages measured in the second station, and the corresponding voltage U''_{Qp} one period or one half-period later,
cₚ is formed as the vectorial difference between the voltages corresponding to aₚ and bₚ,
c_{q} is formed as the vectorial difference between the voltages corresponding to a_{q} and b_{q},
with the aid of the voltage differences formed, the following equations are formed 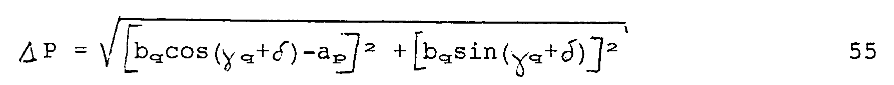 and 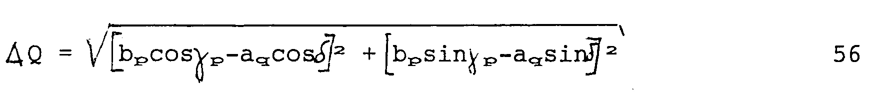 where 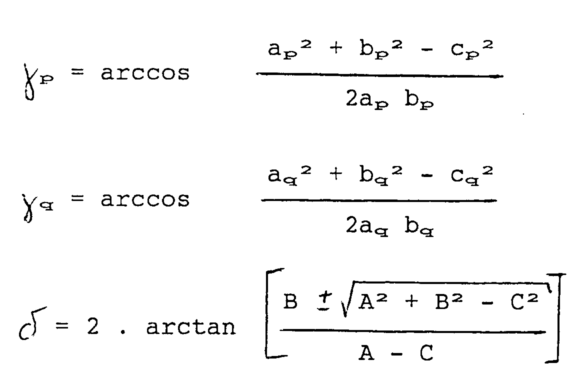 with
${\text{A = b}}_{\text{p}} {\text{b}}_{\text{q}} {\text{sin(γ}}_{\text{p}} {\text{-γ}}_{\text{q}} \text{) 47}$
${\text{B = a}}_{\text{p}} {\text{a}}_{\text{q}} {\text{- b}}_{\text{p}} {\text{b}}_{\text{q}} {\text{cos(γ}}_{\text{p}} {\text{-γ}}_{\text{q}} \text{) 48}$
${\text{C = a}}_{\text{q}} {\text{b}}_{\text{q}} {\text{sinγ}}_{\text{q}} {\text{- a}}_{\text{p}} {\text{b}}_{\text{p}} {\text{sinγ}}_{\text{p}} \text{49}$
and the distance between the first station and a fault point (F) on the transmission line between the first station and the second station with a mutual distance PQ is obtained as

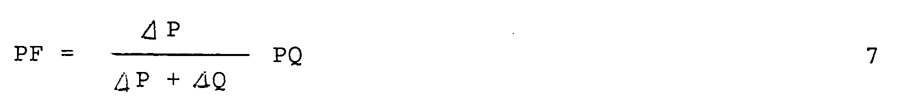

2. Method for locating a fault on a power line located between a first (P) and a second (Q) station , which line is included in a multi-phase distribution or transmission system, with measurement of the instantaneous values of the current and the voltage in each phase at the two end points (P, Q) of the transmission line, with converting the measured values into corresponding digital values, which are then supplied to a travelling wave model (2, 3) in the respective station, and with obtaining the voltage distribution along the transmission line, seen both from station P to station Q and from station Q to station P, with the aid of the travelling wave models, wherein
when the difference in argument between the complex impedances of the power sources and the transmission line is less than 10 degrees
ΔU_{Pp} is formed as the difference between the voltage U'_{P}, measured in the first station (P) or calculated by means of the travelling wave model, and the corresponding voltage U''_{P} one period or one half-period later,
ΔU_{Qq} is formed as the difference between the voltage U'_{Q}, measured in the second station (Q) or calculated by means of the travelling wave model, and the corresponding voltage U''_{Q} one period or one half-period later,
ΔU_{Pq} is formed as the difference between the voltage U'_{Pq} in the second station (Q), calculated in the travelling wave model in the first station (P) with values of currents and voltages measured in the first station, and the corresponding voltage U''_{Pq} one period or one half-period later,
ΔU_{Qp} is formed as the difference between the voltage U'_{Qp} in the first station (P), calculated in the travelling wave model in the second station (Q) with values of currents and voltages measured in the second station, and the corresponding voltage U''_{Qp} one period or one half-period later,
with the aid of the voltage differences formed, the following equations are formed
${\text{ΔP = ΔU}}_{\text{Qp}} {\text{- ΔU}}_{\text{Pp}} \text{5}$
and ${\text{ΔQ = ΔU}}_{\text{Pq}} {\text{- ΔU}}_{\text{Qq}} \text{6}$
and the distance between the first station and a fault point (F) on the transmission line between the first station and the second station with a mutual distance PQ is obtained as

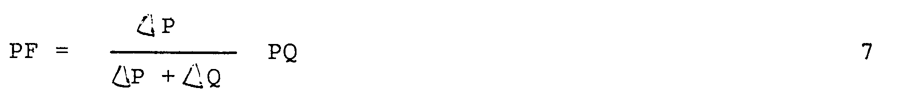

3. Method according to claim 1 or 2, **characterized** in that in the travelling wave models the voltage distribution along the whole transmission line, seen from the respective station, can be calculated.

4. Method according to claim 1 or 2, **characterized** in that in the travelling wave models, only the voltage in the first and the second station can be calculated.

5. Method according to any of the preceding claims, **characterized** in that voltages delivered from the travelling wave models are representing phase voltages.

6. Method according to any of claims 1 to 4, **characterized** in that the voltages delivered from the travelling wave models are representing principal voltages.

7. Method according to any of the preceding claims, **characterized** in that the voltages delivered from the travelling wave models are representing negative or zero sequence voltages.

8. Method according to any of the preceding claims, **characterized** in that the value of aₚ, bₚ, cₚ and a_{q}, b_{q}, c_{q} consist of the rectified mean value, the R.M.S. or the peak value of the corresponding voltages.

9. Equipment for carrying out the method according to any of claims 1 or 3 to 8 comprising devices in both stations, which devices consist of analog-digital convertors (1, 2), travelling wave models (3, 4), summators (5, 6, 7, 8, 15, 18, 19), devices for division (16), devices for multiplication (17), a transmitter (9), a receiver (10) and a calculator (20), wherein
a first summator (5) is arranged to form a difference voltage ${\text{a}}_{\text{p}} {\text{=|ΔU}}_{\text{Pp}} \text{|}$ as the difference between the voltage U'_{P}, measured in the first station (P) or calculated by means of the travelling wave model, and the corresponding voltage U''_{P} one period or one half-period later,
a second summator (7) is arranged to form a difference voltage ${\text{a}}_{\text{q}} {\text{=|ΔU}}_{\text{Qq}} \text{|}$ as the difference between the voltage U'_{Q}, measured in the second station (Q) or calculated by means of the travelling wave model, and the corresponding voltage U''_{Q} one period or one half-period later,
a third summator (6) is arranged to form a difference voltage ${\text{b}}_{\text{p}} {\text{=|ΔU}}_{\text{Pq}} \text{|}$ as the difference between the voltage U'_{Pq} in the second station (Q), calculated in the travelling wave model in the first station (P) with values of currents and voltages measured in the first station, and the corresponding voltage U''_{Pq} one period or one half-period later,
a fourth summator (8) is arranged to form a difference voltage ${\text{b}}_{\text{q}} {\text{=|ΔU}}_{\text{Qp}} \text{|}$ as the difference between the voltage U'_{Qp} in the first station (P), calculated in the travelling wave model in the second station (Q) with values of currents and voltages measured in the second station, and the corresponding voltage U''_{Qp} one period or one half-period later,
a fifth summator (18) is arranged to form the vectorial difference cₚ between the voltages corresponding to aₚ and bₚ,
a sixth summator (19) is arranged to form the vectorial difference c_{q} between the voltages corresponding to a_{q} and b_{q},
the difference voltages a_{q}, b_{q} and c_{q} are transmitted, via the transmitter and the receiver, from the second station (Q) to the first station (P),
the difference voltages aₚ, bₚ and cₚ are supplied, together with the values of a_{q}, b_{q} and c_{q} transmitted to the first station, to the calculator,
the calculator is arranged to calculate 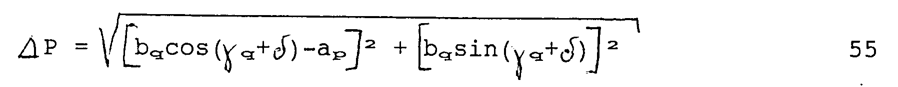 and 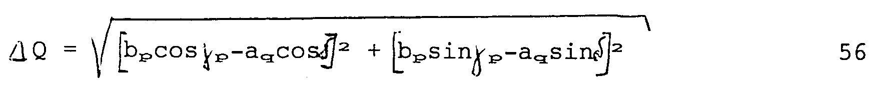 where 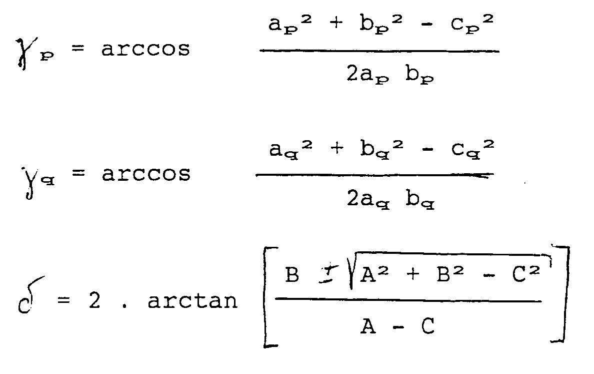 with
${\text{A = b}}_{\text{p}} {\text{b}}_{\text{q}} {\text{sin(γ}}_{\text{p}} {\text{-γ}}_{\text{q}} \text{) 47}$
${\text{B = a}}_{\text{p}} {\text{a}}_{\text{q}} {\text{- b}}_{\text{p}} {\text{b}}_{\text{q}} {\text{cos(γ}}_{\text{p-}} {\text{γ}}_{\text{q}} \text{) 48}$
${\text{C = a}}_{\text{q}} {\text{b}}_{\text{q}} {\text{sinγ}}_{\text{q}} {\text{- a}}_{\text{p}} {\text{b}}_{\text{p}} {\text{sinγ}}_{\text{p}} \text{49}$
a seventh summator (15) is arranged to form the sum of Δp and ΔQ,
the quotient between ΔP and the sum of ΔP and ΔQ is to be generated in the member (16) for division,
and the distance PF between the first station and a fault point F on the transmission line between the first and the second stations with a mutual distance PQ is obtained by multiplying PQ in a multiplier (17) by the quotient between ΔP and the sum $\text{ΔP + ΔQ}$ , obtained from said member (16).

10. Equipment for carrying out the method according to any of claims 2 to 8 comprising devices in both stations, which devices consist of analog-digital convertors (1, 2), travelling wave models (3, 4), summators (5, 6, 7, 8, 11, 12, 15), devices for division (16), devices for multiplication (17), a transmitter (9) and a receiver (10), wherein when the difference in argument between the complex impedances of the power sources and the transmission line is smaller than 10 degrees,
a first summator (5) is arranged to form a difference voltage ΔU_{Pp} as the difference between the voltage U'_{P}, measured in the first station (P) or calculated by means of the travelling wave model, and the corresponding voltage U''_{P} one period or one half-period later,
a second summator (7) is arranged to form a difference voltage ΔU_{Qq} as the difference between the voltage U'_{Q}, measured in the second station (Q) or calculated by means of the travelling wave model, and the corresponding voltage U''_{Q} one period or one half-period later,
a third summator (6) is arranged to form a difference voltage ΔU_{Pq} as the difference between the voltage U'_{Pq} in the second station (Q), calculated in the travelling wave model in the first station (P) with values of currents and voltages measured in the first station, and the corresponding voltage U''_{Pq} one period or one half-period later,
a fourth summator (8) is arranged to form a difference voltage ΔU_{Qp} as the difference between the voltage U'_{Qp} in the first station (P), calculated in the travelling wave model in the second station (Q) with values of currents and voltages measured in the second station, and the corresponding voltage U''_{Qp} one period or one half-period later,
the difference voltage ΔU_{Pp} is supplied, together with the value of ΔU_{Qp} transmitted to the first station, to an eighth summator (11) to form the difference ΔP between ΔU_{Qp} and ΔU_{Pp},
the difference voltage ΔU_{Pq} is supplied, together with the values of ΔU_{Qq} transmitted to the first station, to to an ninth summator (12) to form the difference ΔQ between ΔUP_{q} and ΔU_{Qq},
a seventh summator (15) is arranged to form the sum of ΔP and ΔQ,
a member (16) for division is arranged to form the quotient between ΔP and the sum of ΔP and ΔQ,
and the distance PF between the first station and a fault point F on the transmission line between the first and the second stations with a mutual distance PQ is obtained by multiplying PQ in a multiplier (17) by the quotient between ΔP and the sum $\text{ΔP + ΔQ}$ , obtained from said member (16).

## Patentansprüche

1. Verfahren zur Bestimmung des Ortes eines Fehlers auf einer Energieübertragungsleitung, die sich zwischen einer ersten Station (P) und einer zweiten Station (Q) erstreckt und die zu einem mehrphasigen Verteilungs- oder Übertragungssystem gehört, bei welchem Verfahren die Augenblickswerte des Stromes und der Spannung in jeder Phase an den beiden Endpunkten (P, Q) der Übertragungsleitung gemessen werden, bei welchem Verfahren die gemessenen Werte in entsprechende digitale Werte umgeformt werden, die dann einem Wanderwellenmodell (2, 3) in der entsprechenden Station zugeführt werden, und bei welchem Verfahren die Verteilung der Spannung längs der Übertragungsleitung sowohl in Richtung von der Station P zur Station Q als auch in Richtung von der Station Q zur Station P mit Hilfe des Wanderwellenmodells ermittelt wird, wobei
${\text{a}}_{\text{p}} {\text{= |ΔU}}_{\text{Pp}} \text{|}$ gebildet wird als Differenz aus der Spannung U'_{P}, die in der ersten Station (P) gemessen oder mittels des Wanderwellenmodells berechnet wird, und der entsprechenden Spannung U''_{P} eine Periode oder eine halbe Periode später,
${\text{a}}_{\text{q}} {\text{= |ΔU}}_{\text{Qq}} \text{|}$ gebildet wird als Differenz aus der Spannung U'_{Q}, die in der zweiten Station (Q) gemessen oder mittels des Wanderwellenmodells berechnet wird, und der entsprechenden Spannung U''_{Q} eine Periode oder eine halbe Periode später,
${\text{b}}_{\text{p}} {\text{= |ΔU}}_{\text{Pq}} \text{|}$ gebildet wird als Differenz aus der Spannung U'_{Pq} in der zweiten Station (Q), die in dem Wanderwellenmodell in der ersten Station (P) mit Werten von in der ersten Station gemessenen Strömen und Spannungen berechnet wird, und der entsprechenden Spannung U''_{Pq} eine Periode oder eine halbe Periode später,
${\text{b}}_{\text{q}} {\text{= |ΔU}}_{\text{Qp}} \text{|}$ gebildet wird als Differenz aus der Spannung U'_{Qp} in der ersten Station (P), die in dem Wanderwellenmodell in der zweiten Station (Q) mit Werten von in der zweiten Station gemessenen Strömen und Spannungen berechnet wird, und der entsprechenden Spannung U''_{Qp} eine Periode oder eine halbe Periode später,
cₚ als die vektorielle Differenz aus den Spannungen, die aₚ und bₚ entsprechen, gebildet wird,
c_{q} als die vektorielle Differenz aus den Spannungen, die a_{q} und b_{q} entsprechen, gebildet wird,
mit Hilfe der Spannungsdifferenzen die folgenden Gleichungen gebildet werden 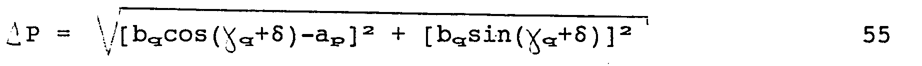 und 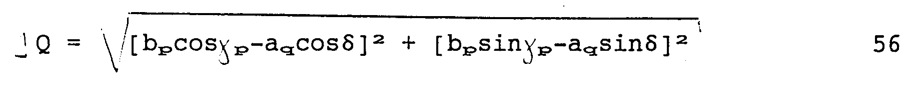 wobei 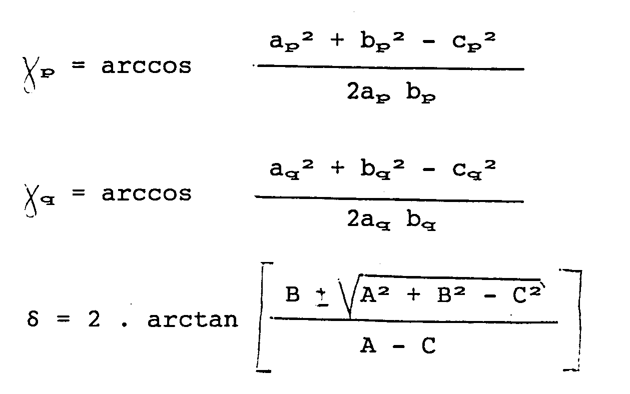 und
${\text{A = b}}_{\text{p}} {\text{b}}_{\text{q}} {\text{sin(γ}}_{\text{p}} {\text{-γ}}_{\text{q}} \text{) 47}$
${\text{B = a}}_{\text{p}} {\text{a}}_{\text{q}} {\text{- b}}_{\text{p}} {\text{b}}_{\text{q}} {\text{cos(γ}}_{\text{p}} {\text{-γ}}_{\text{q}} \text{48}$
${\text{C = a}}_{\text{q}} {\text{b}}_{\text{q}} {\text{sinγ}}_{\text{q}} {\text{- a}}_{\text{p}} {\text{b}}_{\text{p}} {\text{sinγ}}_{\text{p}} \text{49}$
und der Abstand zwischen der ersten Station und einer Fehlerstelle (F) auf der Übertragungsleitung zwischen der ersten Station und der zweiten Station mit einem gegenseitigen Abstand PQ sich ergibt als

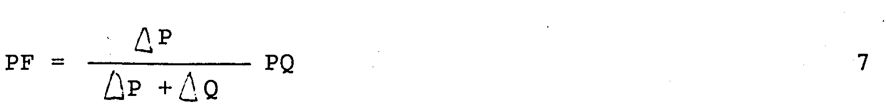

2. Verfahren zur Bestimmung des Ortes eines Fehlers auf einer Energieübertragungsleitung, die sich zwischen einer ersten Station (P) und einer zweiten Station (Q) erstreckt und die zu einem mehrphasigen Verteilungs- oder Übertragungssystem gehört, bei welchem Verfahren die Augenblickswerte des Stromes und der Spannung in jeder Phase an den beiden Endpunkten (P, Q) der Übertragungsleitung gemessen werden, bei welchem Verfahren die gemessenen Werte in entsprechende digitale Werte umgeformt werden, die dann einem Wanderwellenmodell (2, 3) in der entsprechenden Station zugeführt werden, und bei welchem Verfahren die Verteilung der Spannung längs der Übertragungsleitung sowohl in Richtung von der Station P zur Station Q als auch in Richtung von der Station Q zur Station P mit Hilfe des Wanderwellenmodells ermittelt wird, wobei
wenn die Winkeldifferenz zwischen den komplexen Impedanzen der Leistungsquellen und der Übertragungsleitung weniger als 10° beträgt,
ΔU_{Pp} gebildet wird als Differenz aus der Spannung U'_{P}, die in der ersten Station (P) gemessen oder mittels des Wanderwellenmodells berechnet wird, und der entsprechenden Spannung U''_{P} eine Periode oder eine halbe Periode später,
ΔU_{Qq} gebildet wird als Differenz aus der Spannung U'_{Q}, die in der zweiten Station (Q) gemessen oder mittels des Wanderwellenmodells berechnet wird, und der entsprechenden Spannung U''_{Q} eine Periode oder eine halbe Periode später,
ΔU_{Pq} gebildet wird als Differenz aus der Spannung U'_{Pq} in der zweiten Station (Q), die in dem Wanderwellenmodell in der ersten tation (P) mit Werten von in der zweiten Station gemessenen Strömen und Spannungen berechnet wird, und der entsprechenden Spannung U''_{Pq} eine Periode oder eine halbe Periode später,
ΔU_{Qp} gebildet wird als Differenz aus der Spannung U'_{Qp} in der ersten Station (P), die in dem Wanderwellenmodell in der zweiten Station (Q) mit Werten von in der ersten Station gemessenen Strömen und Spannungen berechnet wird, und der entsprechenden Spannung U''_{Qp} eine Periode oder eine halbe Periode später,
mit Hilfe der Spannungsdifferenzen die folgenden Gleichungen gebildet werden
${\text{ΔP = ΔU}}_{\text{Qp}} {\text{- ΔU}}_{\text{Pp}} \text{5}$
und
${\text{ΔQ = ΔU}}_{\text{Pq}} {\text{- ΔU}}_{\text{Qq}} \text{6}$
und der Abstand zwischen der ersten Station und einer Fehlerstelle (F) auf der Übertragungsleitung zwischen der ersten Station und der zweiten Station mit einem gegenseitigen Abstand PQ sich ergibt als

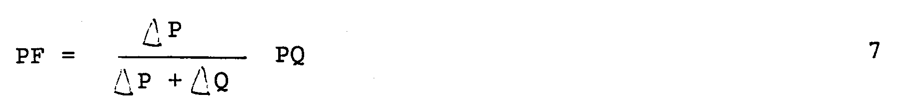

3. Verfahren nach einem der Ansprüche 1 oder 2, **dadurch gekennzeichnet,** daß in den Wanderwellenmodellen die Spannungsverteilung längs der gesamten Übertragungsleitung, gesehen von der betreffenden Station aus, berechnet werden kann.

4. Verfahren nach einem der Ansprüche 1 oder 2, **dadurch gekennzeichnet,** daß in den Wanderwellenmodellen nur die Spannung in der ersten und der zweiten Station berechnet werden kann.

5. Verfahren nach einem der vorhergehenden Ansprüche, **dadurch gekennzeichnet,** daß die Spannungen, die von den Wanderwellenmodellen geliefert werden, Phasenspannungen darstellen.

6. Verfahren nach einem der Ansprüche 1 bis 4, **dadurch gekennzeichnet,** daß die von den Wanderwellenmodellen gelieferten Spannungen die verketteten Spannungen darstellen.

7. Verfahren nach einem der vorhergehenden Ansprüche, **dadurch gekennzeichnet,** daß die von den Wanderwellenmodellen gelieferten Spannungen das gegenläufige Spannungssystem oder das Nullspannungssystem darstellen.

8. Verfahren nach einem der vorhergehenden Ansprüche, **dadurch gekennzeichnet,** daß die Werte aₚ, bₚ, cₚ und a_{q}, b_{q}, c_{q} den gleichgerichteten Mittelwert, den Effektivwert oder den Spitzenwert der entsprechenden Spannungen darstellen.

9. Ausrüstung zur Durchführung des Verfahrens nach einem der Ansprüche 1 oder 3 bis 8 mit Anordnungen in beiden Stationen, die aus Analog-Digital-Wandlern (1, 2), Wanderwellenmodellen (3, 4), Summierungsgliedern (5, 6, 7, 8, 15, 18, 19), Divisionsgliedern (16), Multiplikationsgliedern (17), einem Übertrager (9), einem Empfänger (10) und einem Rechner (20) bestehen, wobei
ein erstes Summierungsglied (5) angeordnet ist zur Bildung einer Differenzspannung ${\text{a}}_{\text{p}} {\text{= |ΔU}}_{\text{Pp}} \text{|}$ aus der Differenz zwischen der Spannung U'_{P}, die in der ersten Station (P) gemessen wird oder mit Hilfe des Wanderwellenmodells berechnet wird, und der entsprechenden Spannung U''_{P} eine Periode oder eine halbe Periode später,
ein zweites Summierungsglied (7) angeordnet ist zur Bildung einer Differenzspannung ${\text{a}}_{\text{q}} {\text{= |ΔU}}_{\text{Qp}} \text{|}$ aus der Differenz zwischen der Spannung U'_{Q}, die in der zweiten Station (Q) gemessen wird oder mit Hilfe des Wanderwellenmodells berechnet wird, und der entsprechenden Spannung U''_{Q} eine Periode oder eine halbe Periode später,
ein drittes Summierungsglied (6) angeordnet ist zur Bildung einer Differenzspannung ${\text{b}}_{\text{p}} {\text{= |ΔU}}_{\text{Pq}} \text{|}$ aus der Differenz zwischen der Spannung U'_{Pq} in der zweiten Station (Q), die in der ersten Station (P) aus den in der ersten Station gemessenen Strom- und Spannungswerten von dem Wanderwellenmodell berechnet wird, und der entsprechenden Spannung U''_{Pq} eine Periode oder eine halbe Periode später,
ein viertes Summierungsglied (8) angeordnet ist zur Bildung einer Differenzspannung ${\text{b}}_{\text{q}} {\text{= |ΔU}}_{\text{Qp}} \text{|}$ aus der Differenz zwischen der Spannung U'_{Qp} in der ersten Station (P), die in der zweiten Station (Q) aus den in der zweiten Station gemessenen Strom- und Spannungswerten von dem Wanderwellenmodell berechnet wird, und der entsprechenden Spannung U''_{Qp} eine Periode oder eine halbe Periode später,
ein fünftes Summierungsglied (18) vorhanden ist zur Bildung der vektoriellen Differenz cₚ zwischen den Spannungen, die aₚ und bₚ entsprechen,
ein sechstes Summierungsglied (19) vorhanden ist zur Bildung der vektoriellen Differenz c_{q} zwischen den Spannungen, die a_{q} und b_{q} entsprechen,
die Differenzspannungen a_{q}, b_{q} und c_{q} über den Übertrager und den Empfänger von der zweiten Station (Q) zu der ersten Station (P) übertragen werden,
die Differenzspannungen aₚ, bₚ und cₚ, zusammen mit den Werten von a_{q}, b_{q} und c_{q}, die zu der ersten Station übertragen werden, dem Rechner zugeführt werden,
der Rechner so beschaffen ist, daß er berechnet 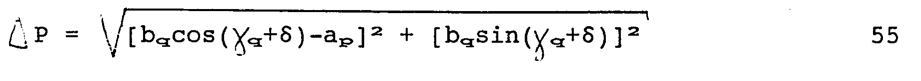 und 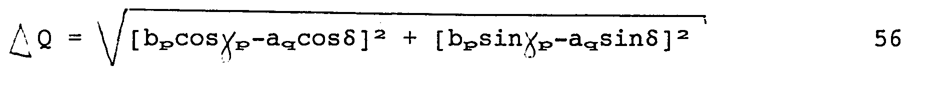 wobei 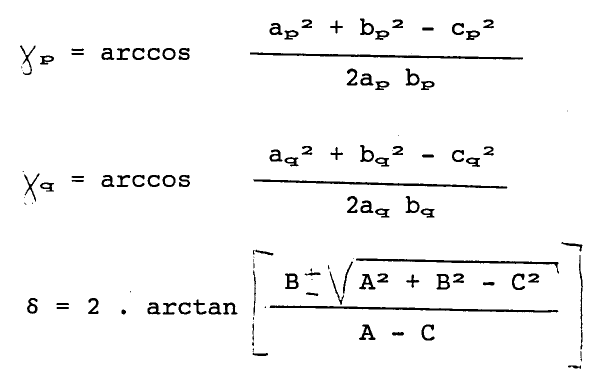 und
${\text{A = b}}_{\text{p}} {\text{b}}_{\text{q}} {\text{sin(γ}}_{\text{p}} {\text{-γ}}_{\text{q}} \text{) 47}$
${\text{B = a}}_{\text{p}} {\text{a}}_{\text{q}} {\text{- b}}_{\text{p}} {\text{b}}_{\text{q}} {\text{cos(γ}}_{\text{p}} {\text{-γ}}_{\text{q}} \text{) 48}$
${\text{C = a}}_{\text{q}} {\text{b}}_{\text{q}} {\text{sinγ}}_{\text{q}} {\text{- a}}_{\text{p}} {\text{b}}_{\text{p}} {\text{sinγ}}_{\text{p}} \text{49}$
ein siebentes Summierungsglied (15) vorhanden ist zur Bildung der Summe aus ΔP und ΔQ,
der Quotient aus ΔP und der Summe aus ΔP und ΔQ in dem Divisionsglied (16) gebildet wird,
und die Entfernung PF zwischen der ersten Station und einer Fehlerstelle F auf der Übertragungsleitung zwischen der ersten und der zweiten Station mit einem gegenseitigen Abstand PQ durch Multiplikation von PQ mit dem Quotienten aus ΔP und der Summe $\text{ΔP + ΔQ}$ , die von dem genannten Glied (16) geliefert wird, in einem Multiplizierglied (17) gewonnen wird.

10. Ausrüstung zur Durchführung des Verfahrens nach einem der Ansprüche 2 bis 8 mit Anordnungen in beiden Stationen, die aus Analog-Digital-Wandlern (1, 2), Wanderwellenmodellen (3, 4), Summierungsgliedern (5, 6, 7, 8, 11, 12, 15), Divisionsgliedern (16), Multiplikationsgliedern (17), einem Übertrager (9) und einem Empfänger (10) bestehen, wobei
wenn die Winkeldifferenz zwischen den komplexen Impedanzen der Leistungsquellen und der Übertragungsleitung weniger als 10° beträgt,
ein erstes Summierungsglied (5) angeordnet ist zur Bildung einer Differenzspannung ΔU_{Pp} aus der Differenz zwischen der Spannung U'_{P}, die in der ersten Station (P) gemessen wird oder mit Hilfe des Wanderwellenmodells berechnet wird, und der entsprechenden Spannung U''_{P} eine Periode oder eine halbe Periode später,
ein zweites Summierungsglied (7) angeordnet ist zur Bildung einer Differenzspannung ΔU_{Qp} aus der Differenz zwischen der Spannung U'_{Q}, die in der zweiten Station (Q) gemessen wird oder mit Hilfe des Wanderwellenmodells berechnet wird, und der entsprechenden Spannung U''_{Q} eine Periode oder eine halbe Periode später,
ein drittes Summierungsglied (6) angeordnet ist zur Bildung einer Differenzspannung ΔU_{Pq} aus der Differenz zwischen der Spannung U'_{Pq} in der zweiten Station (Q), die in der ersten Station (P) aus den in der ersten Station gemessenen Strom- und Spannungswerten von dem Wanderwellenmodell berechnet wird, und der entsprechenden Spannung U''_{Pq} eine Periode oder eine halbe Periode später,
ein viertes Summierungsglied (8) angeordnet ist zur Bildung einer Differenzspannung ΔU_{Qp} aus der Differenz zwischen der Spannung U'_{Qp} in der ersten Station (P), die in der zweiten Station (Q) aus den in der zweiten Station gemessenen Strom- und Spannungswerten von dem Wanderwellenmodell berechnet wird, und der entsprechenden Spannung U''_{Qp} eine Periode oder eine halbe Periode später,
die Differenzspannung ΔU_{Pp} zusammen mit dem Wert von ΔU_{Qp}, der der ersten Station zugeführt wird, einem achten Summierungsglied (11) zugeführt wird zur Bildung der Differenz aus ΔP einerseits und ΔU_{Qp} und ΔU_{Pp} andererseits,
die Differenzspannung ΔU_{Pq} zusammen mit dem Wert von ΔU_{Qp}, der der ersten Station zugeführt wird, einem neunten Summierungsglied (12) zugeführt wird zur Bildung der Differenz aus ΔQ einerseits und ΔU_{Pq} und ΔU_{Qq} andererseits,
ein siebentes Summierungsglied (15) vorhanden ist zur Bildung der Summe aus ΔP und ΔQ,
ein Divisionsglied (16) vorhanden ist zur Bildung des Quotienten aus ΔP und der Summe aus ΔP und ΔQ,
und die Entfernung PF zwischen der ersten Station und einer Fehlerstelle F auf der Übertragungsleitung zwischen der ersten und der zweiten Station mit einem gegenseitigen Abstand PQ durch Multiplikation von PQ mit dem Quotienten aus ΔP und der Summe $\text{ΔP + ΔQ}$ , die von dem genannten Glied (16) geliefert wird, in einem Multiplizierglied (17) gewonnen wird.

## Revendications

1. Procédé de localisation d'un défaut sur une ligne de transport d'énergie située entre une première station (P) et une seconde station (Q), cette ligne faisant partie d'un système de distribution ou de transport d'énergie multiphasé, ce procédé comprenant la mesure des valeurs instantanées du courant et de la tension dans chaque phase aux deux extrémités(P, Q) de la ligne de transport, la conversion des valeurs mesurées en valeurs numériques correspondantes qui sont ensuite appliquées à un modèle d'ondes progressives (2, 3) dans la station respective, et l'obtention de la distribution de tension le long de la ligne de transport, vue de la station P vers la station Q et de la station Q vers la station P, à l'aide des modèles d'ondes progressives, dans lequel :
on forme ${\text{a}}_{\text{p}} {\text{= |Δ U}}_{\text{Pp}} \text{|}$ qui est la différence entre la tension U'_{P}, mesurée à la première station (P) ou calculée au moyen du modèle d'ondes progressives, et la tension U''_{P} correspondante une période ou une demi-période plus tard, on forme ${\text{a}}_{\text{q}} {\text{= |Δ U}}_{\text{Qq}} \text{|}$ qui est la différence entre la tension U'_{Q}, mesurée dans la seconde station (Q) ou calculée au moyen du modèle d'ondes progressives, et la tension U''_{Q} correspondante une période ou une demi-période plus tard, on forme ${\text{b}}_{\text{p}} {\text{= |Δ U}}_{\text{Pq}} \text{|}$ qui est la différence entre la tension U'_{Pq} dans la seconde station (Q), calculée par le modèle d'ondes progressives dans la première station (P), avec des valeurs de courants et de tensions mesurées dans la première station, et la tension U''_{Pq} correspondante une période ou une demi-période plus tard,
on forme ${\text{b}}_{\text{q}} {\text{= |Δ U}}_{\text{Qp}} \text{|}$ qui est la différence entre la tension U'_{Qp} dans la première station (P), calculée par le modèle d'ondes progressives dans la seconde station (Q) avec des valeurs de courants et de tensions mesurées dans la seconde station, et la tension U''_{Qp} correspondante une période ou une demi-période plus tard,
on forme cₚ qui est la différence vectorielle entre les tensions correspondant à aₚ et bₚ,
on forme c_{q} qui est la différence vectorielle entre les tensions correspondant à a_{q} et b_{q},
à l'aide des différences de tension, ainsi formées, on forme les relations suivantes : 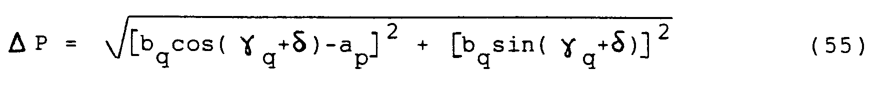 et 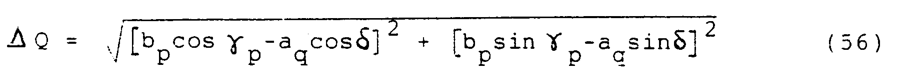 avec 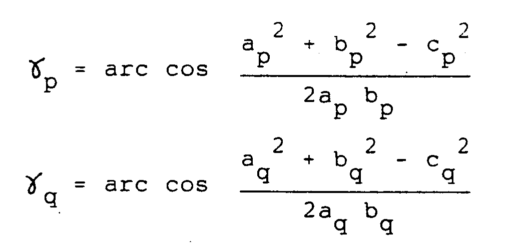 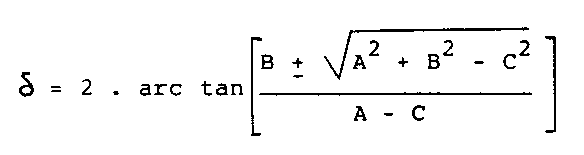 et avec
${\text{A = b}}_{\text{p}} {\text{b}}_{\text{q}} {\text{sin(γ}}_{\text{p}} {\text{- γ}}_{\text{q}} \text{) (47)}$
${\text{B = a}}_{\text{p}} {\text{a}}_{\text{q}} {\text{- b}}_{\text{p}} {\text{b}}_{\text{q}} {\text{cos(γ}}_{\text{p}} {\text{- γ}}_{\text{q}} \text{) (48)}$
${\text{C = a}}_{\text{q}} {\text{b}}_{\text{q}} {\text{sin γ}}_{\text{q}} {\text{- a}}_{\text{p}} {\text{b}}_{\text{p}} {\text{sin γ}}_{\text{p}} \text{(49)}$
et on détermine la distance entre la première station et un point de défaut (F) sur la ligne de transport entre la première station et la seconde station, situées à une distance mutuelle PQ, par la relation :

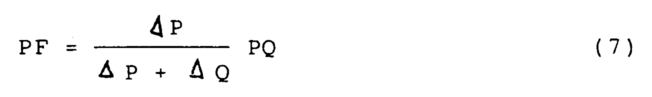

2. Procédé de localisation d'un défaut sur une ligne de transport d'énergie située entre une première station (P) et une seconde station (Q), cette ligne faisant partie d'un système de distribution ou de transport d'énergie multiphasé, ce procédé comprenant la mesure des valeurs instantanées du courant et de la tension dans chaque phase aux deux extrémités (P, Q) de la ligne de transport, la conversion des valeurs mesurées en valeurs numériques correspondantes qui sont ensuite appliquées à un modèle d'ondes progressives (2, 3) dans la station respective, et l'obtention de la distribution de tension le long de la ligne de transport, vue de la station P vers la station Q et de la station Q vers la station P, à l'aide des modèles d'ondes progressives, dans lequel :
lorsque la différence d'argument entre les impédances complexes des sources d'énergie et la ligne de transport est inférieure à 10 degrés :
on forme Δ U_{Pp} qui est la différence entre la tension U'_{P}, mesurée dans la première station (P) ou calculée au moyen du modèle d'ondes progressives, et la tension correspondante U''_{P} une période ou une demi-période plus tard,
on forme Δ U_{Qq} qui est la différence entre la tension U'_{Q}, mesurée dans la seconde station (Q) ou calculée au moyen du modèle d'ondes progressives, et la tension U''_{Q} correspondante une période ou une demi-période plus tard,
on forme Δ U_{Pq} qui est la différence entre la tension U'_{Pq} dans la seconde station (Q), calculée par le modèle d'ondes progressives dans la première station (P) avec des valeurs de courants et de tensions mesurées dans la première station, et la tension U''_{Pq} correspondante une période ou une demi-période plus tard,
on forme Δ U_{Qp} qui est la différence entre la tension U'_{Qp} dans la première station (P), calculée par le modèle d'ondes progressives dans la seconde station (Q) avec des valeurs de courants et de tensions mesurées dans la seconde station, et la tension U''_{Qp} correspondante une période ou une demi-période plus tard,
à l'aide des différences de tension ainsi formées, on forme les relations :
${\text{Δ P = Δ U}}_{\text{Qp}} {\text{- Δ U}}_{\text{Pp}} \text{(5)}$
et
${\text{Δ Q = Δ U}}_{\text{Pq}} {\text{- Δ U}}_{\text{Qq}} \text{(6)}$
et on détermine la distance entre la première station et un point de défaut (F) sur la ligne de transport entre la première station et la seconde station, situées à une distance mutuelle PQ, au moyen de la relation :

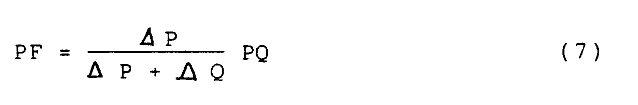

3. Procédé selon la revendication 1 ou 2, **caractérisé** en ce que les modèles d'ondes progressives permettent de calculer la distribution de tension le long de la totalité de la ligne de transport, vue de la station respective.

4. Procédé selon la revendication 1 ou 2, **caractérisé** en ce que les modèles d'ondes progressives permettent seulement de calculer la tension aux première et seconde stations.

5. Procédé selon l'une quelconque des revendications précédentes, **caractérisé** en ce que les tensions que fournissent les modèles d'ondes progressives représentent des tensions de phases.

6. Procédé selon l'une quelconque des revendications 1 à 4, **caractérisé** en ce que les tensions que fournissent les modèles d'ondes progressives représentent des tensions principales.

7. Procédé selon l'une quelconque des revendications précédentes, **caractérisé** en ce que les tensions que fournissent les modèles d'ondes progressives représentent des tensions inverses ou homopolaires.

8. Procédé selon l'une quelconque des revendications précédentes, **caractérisé** en ce que la valeur de aₚ, bₚ, cₚ et a_{q}, b_{q}, c_{q} est la valeur moyenne redressée, la valeur efficace ou la valeur de crête des tensions correspondantes.

9. Equipement destiné à mettre en oeuvre le procédé selon l'une quelconque des revendications 1 ou 3 à 8 précédentes, comprenant des dispositifs dans les deux stations, ces dispositifs comprenant des convertisseurs analogique-numérique (1, 2), des modèles d'ondes progressives (3, 4), des dispositifs de sommation (5, 6, 7, 8, 15, 18, 19), des dispositifs de division (16), des dispositifs de multiplication (17), un émetteur (9), un récepteur (10) et un calculateur (20), dans lequel : un premier dispositif de sommation (5) est connecté de façon à former une tension de différence ${\text{a}}_{\text{p}} {\text{= |Δ U}}_{\text{Pp}} \text{|}$ qui est la différence entre la tension U'_{P} mesurée dans la première station (P) ou calculée au moyen du modèle d'ondes progressives, et la tension U''_{P} correspondante une période ou une demi-période plus tard,
un second dispositif de sommation (7) est connecté de façon à former une tension de différence ${\text{a}}_{\text{q}} {\text{= |Δ U}}_{\text{Qq}} \text{|}$ 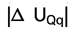 qui est la différence entre la tension U'_{Q}, mesurée dans la seconde station (Q) ou calculée au moyen du modèle d'ondes progressives, et la tension U''_{Q} correspondante une période ou une demi-période plus tard,
un troisième dispositif de sommation (6) est connecté de façon à former une tension de différence ${\text{b}}_{\text{p}} {\text{= |Δ U}}_{\text{Pq}} \text{|}$ 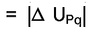 qui est la différence entre la tension U'_{Pq} dans la seconde station (Q), calculée par le modèle d'ondes progressives dans la première station (P) avec des valeurs de courants et de tensions mesurées dans la première station, et la tension U''_{Pq} correspondante une période ou une demi-période plus tard,
un quatrième dispositif de sommation (8) est connecté de façon à former une tension de différence ${\text{b}}_{\text{q}} {\text{= |Δ U}}_{\text{Qp}} \text{|}$ 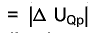 qui est la différence entre la tension U'_{Qp} dans la première station (P), calculée par le modèle d'ondes progressives dans la seconde station (Q) avec des valeurs de courants et de tensions mesurées dans la seconde station, et la tension U''_{Qp} correspondante une période ou une demi-période plus tard,
un cinquième dispositif de sommation (18) est connecté de façon à former la différence vectorielle cₚ entre les tensions correspondant à aₚ et bₚ,
un sixième dispositif de sommation (19) est connecté de façon à former la différence vectorielle c_{q} entre les tensions correspondant à a_{q} et b_{q},
les tensions de différence a_{q}, b_{q} et c_{q} sont transmises, par l'intermédiaire de l'émetteur et du récepteur, de la seconde station (Q) à la première station (P),
les tensions de différence a_{p,} bₚ et cₚ sont appliquées au calculateur, conjointement aux valeurs de a_{q}, b_{q} et c_{q} qui sont transmises vers la première station,
le calculateur est conçu de façon à calculer : 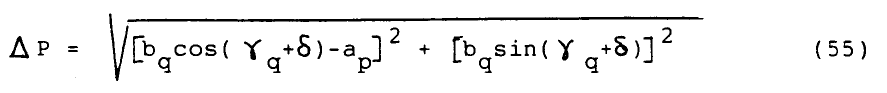 et 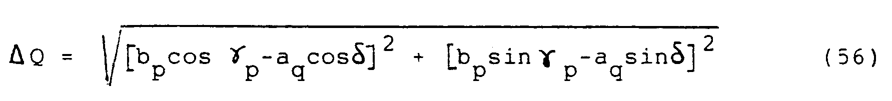 avec 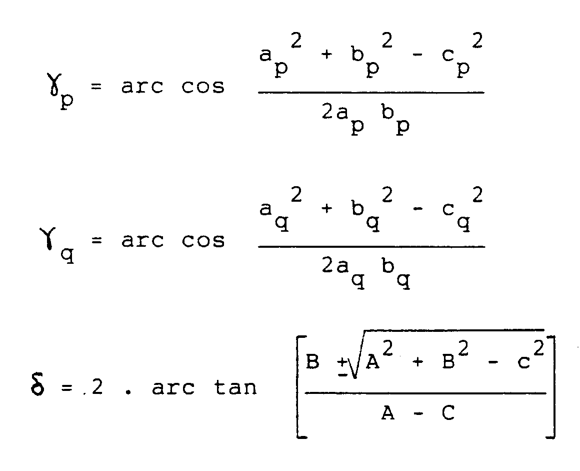 et avec
${\text{A = b}}_{\text{p}} {\text{b}}_{\text{q}} {\text{sin(γ}}_{\text{p}} {\text{- γ}}_{\text{q}} \text{) (47)}$
${\text{B = a}}_{\text{p}} {\text{a}}_{\text{q}} {\text{- b}}_{\text{p}} {\text{b}}_{\text{q}} {\text{cos(γ}}_{\text{p}} {\text{- γ}}_{\text{q}} \text{) (48)}$
${\text{C = a}}_{\text{q}} {\text{b}}_{\text{q}} {\text{sin γ}}_{\text{q}} {\text{- a}}_{\text{p}} {\text{b}}_{\text{p}} {\text{sin γ}}_{\text{p}} \text{(49)}$
un septième dispositif de sommation (15) est connecté de façon à former la somme de Δ P et Δ Q,
le quotient entre Δ P et la somme de Δ P et Δ Q est généré dans le dispositif de division (16),
et la distance PF entre la première station et un point de défaut F sur la ligne de transport entre les première et seconde stations, situées à une distance mutuelle PQ, est obtenue en multipliant PQ dans ++un multiplieur (17) par le quotient entre Δ P et la somme $\text{Δ P + Δ Q}$ , qui est fourni par le dispositif de division (16).

10. Equipement destiné à mettre en oeuvre le procédé selon l'une quelconque des revendications 2 à 8, comprenant des dispositifs dans les deux stations, ces dispositifs comprenant des convertisseurs analogiquenumérique (1, 2), des modèles d'ondes progressives (3, 4), des dispositifs de sommation (5, 6, 7, 8, 11, 12, 15), des dispositifs de division (16), des dispositifs de multiplication (17), un émetteur (9) et un récepteur (10), dans lequel :
lorsque la différence d'argument entre les impédances complexes des sources d'alimentation et de la ligne de transport est inférieure à 10 degrés,
un premier dispositif de sommation (5) est connecté de façon à former une tension de différence Δ U_{Pp} qui est la différence entre la tension U'_{P}, mesurée dans la première station (P) ou calculée au moyen du modèle d'ondes progressives, et la tension U''_{P} correspondante une période ou une demi-période plus tard,
un second dispositif de sommation (7) est connecté de façon à former une tension de différence Δ U_{Qq} est la différence entre la tension U'_{Q}, mesurée dans la seconde station (Q) ou calculée au moyen du modèle d'ondes progressives, et la tension U''_{Q} correspondante une période ou une demi-période plus tard,
un troisième dispositif de sommation (6) est connecté de façon à former une tension de différence Δ U_{Pq} qui est la différence entre la tension U'_{Pq} dans la seconde station (Q), calculée dans le modèle d'ondes progressives dans la première station (P) avec des valeurs de courants et de tensions mesurées dans la première station, et la tension U''_{Pq} correspondante une période ou une demi-période plus tard,
un quatrième dispositif de sommation (8) est connecté de façon à former une tension de différence Δ U_{Qp} qui est la différence entre la tension U'_{Qp} dans la première station (P), calculée dans le modèle d'ondes progressives dans la seconde station (Q) avec des valeurs de courants et de tensions mesurées dans la seconde station, et la tension U''_{Qp} correspondante une période ou une demi-période plus tard,
la tension de différence Δ U_{Pp} est appliquée, conjointement à la valeur de Δ U_{Qp} transmise vers la première station, à un huitième dispositif de sommation (11), pour former la différence Δ P entre Δ U_{Qp} et Δ U_{Pp},
la tension de différence Δ U_{Pq} est appliquée, conjointement aux valeurs de Δ U_{Qq} transmises à la première station, à un neuvième dispositif de sommation (12) pour former la différence Δ Q entre Δ U_{Pq} et Δ U_{Qq},
un septième dispositif de sommation (15) est connecté de façon à former la somme de Δ P et Δ Q,
un dispositif de division (16) est connecté de façon à former le quotient entre Δ P et la somme de Δ P et Δ Q, et la distance PF entre la première station et un point de défaut F sur la ligne de transport entre les première et seconde stations, situées à une distance mutuelle PQ, est obtenue en multipliant PQ dans un multiplieur (17) par le quotient entre Δ P et la somme $\text{Δ P + Δ Q}$ , qui est fournie par le dispositif de division (16).
